# EUROPEAN PATENT APPLICATION

(11) **EP 4 629 280 A1**
(43) Date of publication of application: **08.10.2025**
(21) Application number: 23897881.1
(22) Date of filing: 30.11.2023
(51) Int. Cl.: H01L 21/02, C09D 9/00, C09D 181/00, C09D 183/14

(54) **COMPOSITION FOR FORMING COATING FILM FOR FOREIGN SUBSTANCE REMOVAL, AND SEMICONDUCTOR SUBSTRATE**

(30) Priority: 01.12.2022 JP 2022193033
(71) Applicant: Nissan Chemical Corporation, Tokyo 103-6119 (JP)
(72) Inventor: KAMIBAYASHI, Satoshi, Toyama-shi, Toyama 939-2792 (JP); KISHIOKA, Takahiro, Toyama-shi, Toyama 939-2792 (JP)
(74) Representative: Hoffmann Eitle
(86) International application number: PCT/JP2023/042991
(87) International publication number: WO 2024/117235

(57) **Abstract**

A composition for forming a coating film for removing foreign matters, including: a polymer; and a solvent, the composition being capable of forming a coating film that is removable with a removing liquid,
wherein the polymer is a polymer containing a structure represented by Formula (1) below. 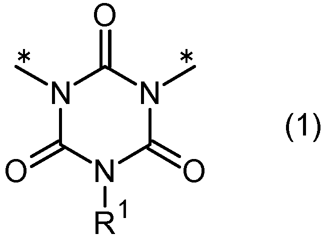 [In Formula (1), R¹ represents a hydrogen atom, a protecting group of an imide group deprotected by an alkali, or a protecting group of an imide group deprotected by an acid, and * represents a bond.]

## Description

### Technical Field

The present invention relates to a composition for forming a coating film for removing foreign matters that can prevent foreign matters from remaining on a substrate by a simple method, a coating film for removing foreign matters, a semiconductor substrate, and a method for producing a processed semiconductor substrate.

### Background Art

In the production of a semiconductor device, particularly in what is called the post-process, studies have been made on the process of bonding a semiconductor substrate (e.g. a wafer) to a support substrate, subjecting the resultant substrate to back-grinding (grinding) and wiring formation steps, and then peeling off the support substrate to form a desired semiconductor substrate.

In such a step, foreign matters may be generated, and removal thereof is required. Therefore, for example, Patent Literatures 1 and 2 each disclose a composition for forming a substrate treatment film and a method for treating a substrate, which can efficiently remove minute particles from the surface of the substrate and easily remove the formed substrate treatment film from the substrate surface, in a process for forming a substrate treatment film on the surface of the semiconductor substrate and removing foreign matters from this substrate surface.

### Citation List

### Patent Literatures

Patent Literature 1: WO 2017/056746 A
Patent Literature 2: WO 2020/008965 A

### Summary of Invention

### Technical Problem

Meanwhile, when a semiconductor substrate is bonded to a support base material, the semiconductor substrate is bonded using an adhesive layer (e.g. a liquid composition containing a polymer, a back-grinding tape, or a dicing tape) having resistance to the subsequent steps (such as a heating step and a chemical liquid treatment step). Alternatively, a support base material having a pressure-sensitive adhesive layer is used. Thereafter, a step of peeling off the semiconductor substrate is performed. In this instance, the adhesive layer or the pressure-sensitive adhesive layer of the support base material may remain as foreign matters (residue) on the substrate. Such a phenomenon remarkably occurs particularly when an adhesive layer is formed directly or when a support base material having a pressure-sensitive adhesive layer is directly attached on the surface of a semiconductor substrate having wiring previously formed on a substrate. In some cases, it is not possible to completely remove the foreign matters, even when cleaning is conducted using a known organic solvent or liquid chemical agent.

Thus, an object of the present invention is to provide a method for producing a processed semiconductor substrate that can prevent a peeled residue generated from an adhesive layer, a pressure-sensitive adhesive layer, or the like from remaining on a semiconductor substrate by a simple method.

In addition, in the step to be performed after the semiconductor substrate is bonded to the support substrate, a treatment at high heating temperatures (e.g. 300°C) may be performed. There is a need for a composition for forming a coating film for removing foreign matters that can prevent foreign matters from remaining on a substrate by a simple method even when the treatment at high temperatures is conducted. Hence, there is a demand for a composition for forming a coating film for removing foreign matters that provides a coating film for removing foreign matters having heat resistance.

Thus, an object of the present invention is to provide a composition for forming a coating film for removing foreign matters from which a coating film for removing foreign matters having heat resistance is obtained, a coating film for removing foreign matters using the composition, a semiconductor substrate, and a method for producing a processed semiconductor substrate.

### Solution to Problem

As a result of intensive studies to solve the above problem, the present inventors have found that the above problem can be solved, thereby completing the present invention having the following gist.

That is, the present invention includes the following.
[1] A composition for forming a coating film for removing foreign matters, including: a polymer; and a solvent, the composition being capable of forming a coating film that is removable with a removing liquid,
   wherein the polymer is a polymer containing a structure represented by Formula (1) below. 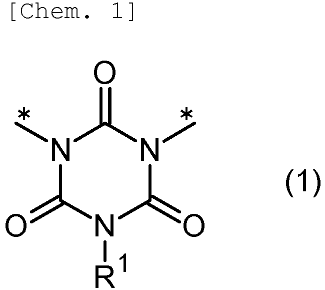
   [In Formula (1), R¹ represents a hydrogen atom, a protecting group of an imide group deprotected by an alkali, or a protecting group of an imide group deprotected by an acid, and * represents a bond.]
[2] The composition according to [1], wherein the polymer further contains a structure represented by Formula (2) below. 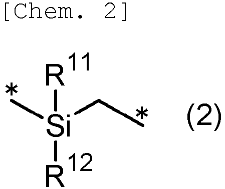 [In Formula (2), R¹¹ and R¹² each independently represent an optionally substituted alkyl group having 1 to 10 carbon atoms, an optionally substituted phenyl group, or an optionally substituted phenoxy group, and * represents a bond.]
[3] The composition according to [1] or [2], wherein the polymer is a polymer obtained by a hydrosilylation reaction between a compound having a Si-H group and a compound having a carbon-carbon unsaturated bond capable of a hydrosilylation reaction.
[4] The composition according to [3], wherein the compound having a carbon-carbon unsaturated bond includes a compound represented by Formula (1A) below. 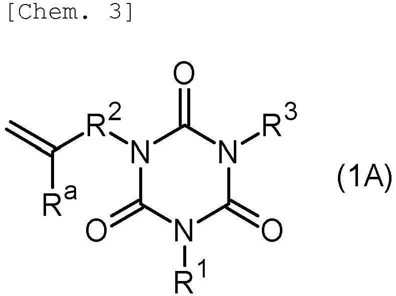
   [In Formula (1A), R¹ represents a hydrogen atom, a protecting group of an imide group deprotected by an alkali, or a protecting group of an imide group deprotected by an acid.
   R² represents a divalent group having 1 to 6 carbon atoms.
   R³ represents a hydrogen atom, a protecting group of an imide group deprotected by an alkali, a protecting group of an imide group deprotected by an acid, or a group represented by Formula (1A-1) below.
   R^{a} represents a hydrogen atom or a methyl group.] 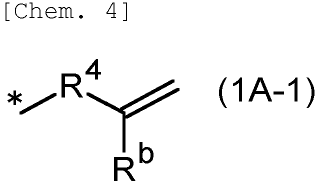
   [In Formula (1A-1), R⁴ represents a divalent group having 1 to 6 carbon atoms. R^{b} represents a hydrogen atom or a methyl group. * represents a bond.]
[5] The composition according to [3] or [4], wherein the compound having a Si-H group includes at least one of a compound represented by Formula (2A) below, a cyclic siloxane compound represented by Formula (2B) below, and a silsesquioxane having a Si-H group. 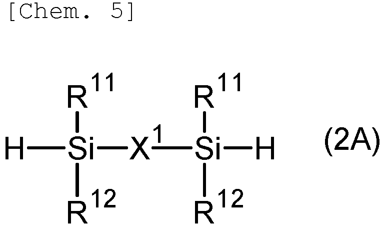
   [In Formula (2A), R¹¹s and R¹²s each independently represent an optionally substituted alkyl group having 1 to 10 carbon atoms, an optionally substituted phenyl group, or an optionally substituted phenoxy group.
   X¹ represents a single bond, an organic group having 1 to 10 carbon atoms, or a group represented by Formula (2A-1) below.] 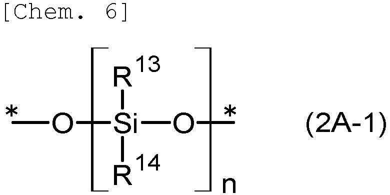
   [In Formula (2A-1), R¹³ and R¹⁴ each independently represent an optionally substituted alkyl group having 1 to 10 carbon atoms, an optionally substituted phenyl group, or an optionally substituted phenoxy group. n represents an integer of 0 to 10. * represents a bond.] 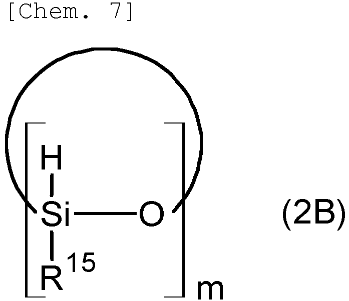
   [In Formula (2B), R¹⁵ each independently represents an optionally substituted alkyl group having 1 to 10 carbon atoms, an optionally substituted phenyl group, or an optionally substituted phenoxy group. m represents an integer of 3 to 6.
[6] The composition according to any one of [1] to [5], wherein the removing liquid is an alkaline removing liquid.
[7] The composition according to any one of [1] to [6], wherein the removing liquid is a removing liquid containing an organic solvent in an amount of 50 mass% or more.
[8] The composition according to any one of [1] to [7], including at least one of a crosslinking agent and an additive.
[9] A coating film for removing foreign matters including the composition according to any one of [1] to [8].
[10] The coating film for removing foreign matters according to [9], wherein a film thickness of the coating film decreases by 5% or less when the coating film is heated at 250°C for 10 minutes in a nitrogen atmosphere.
[11] A semiconductor substrate including the coating film for removing foreign matters according to [9] or [10].
[12] A method for producing a processed semiconductor substrate, including:
   a first A step of producing a laminate by bonding the semiconductor substrate according to [11] to a support base material with the coating film for removing foreign matters interposed therebetween;
   a second A step of processing the laminate;
   a third A step of peeling off the support base material from the laminate; and
   a fourth A step of cleaning the semiconductor substrate or the support base material with a removing liquid to remove the coating film for removing foreign matters.
[13] The method for producing a processed semiconductor substrate according to [12], wherein in the fourth A step, foreign matters are removed together with the coating film for removing foreign matters.
[14] The method for producing a processed semiconductor substrate according to [12] or [13], wherein the first A step is a step of producing a laminate by bonding the semiconductor substrate to the support base material with the coating film for removing foreign matters and an adhesive layer interposed therebetween.
[15] The method for producing a semiconductor substrate according to [14], wherein in the fourth A step, foreign matters as a peeled residue of the adhesive layer are removed together with the coating film for removing foreign matters.
[16] The method for producing a processed semiconductor substrate according to any one of [12] to [15], wherein the processing includes connecting the semiconductor substrate to a second semiconductor substrate.
[17] A method for producing a processed semiconductor substrate, including:
   a first B step of producing a laminate by bonding a semiconductor substrate to a support base material with a coating film for removing foreign matters and an adhesive layer interposed therebetween;
   a second B step of processing the laminate;
   a third B step of peeling off the support base material from the laminate; and
   a fourth B step of cleaning the semiconductor substrate or the support base material with a removing liquid to remove the coating film for removing foreign matters,
   wherein the processing includes connecting the semiconductor substrate to a second semiconductor substrate.

### Advantageous Effects of Invention

An embodiment of the present invention can provide a method for producing a processed semiconductor substrate that can prevent a peeled residue generated from an adhesive layer, a pressure-sensitive adhesive layer, or the like from remaining on the semiconductor substrate by a simple method.

Further, according to an embodiment of the present invention, it is possible to provide a composition for forming a coating film for removing foreign matters from which a coating film for removing foreign matters having heat resistance is obtained, a coating film for removing foreign matters using the composition, a semiconductor substrate, and a method for producing a processed semiconductor substrate.

### Brief Description of Drawings

Fig. 1A is a schematic cross-sectional view for explaining an example of a method for producing a processed semiconductor substrate (part 1).
Fig. 1B is a schematic cross-sectional view for explaining the example of the method for producing a processed semiconductor substrate (part 2).
Fig. 1C is a schematic cross-sectional view for explaining the example of the method for producing a processed semiconductor substrate (part 3).
Fig. 1D is a schematic cross-sectional view for explaining the example of the method for producing a processed semiconductor substrate (part 4).
Fig. 1E is a schematic cross-sectional view for explaining the example of the method for producing a processed semiconductor substrate (part 5).
Fig. 1F is a schematic cross-sectional view for explaining the example of a method for producing a processed semiconductor substrate (part 6).
Fig. 1G is a schematic cross-sectional view for explaining the example of the method for producing a processed semiconductor substrate (part 7).
Fig. 2A is a schematic cross-sectional view for explaining another example of the method for producing a processed semiconductor substrate (part 1).
Fig. 2B is a schematic cross-sectional view for explaining the other example of the method for producing a processed semiconductor substrate (part 2).
Fig. 2C is a schematic cross-sectional view for explaining the other example of the method for producing a processed semiconductor substrate (part 3).
Fig. 2D is a schematic cross-sectional view for explaining the other example of the method for producing a processed semiconductor substrate (part 4).
Fig. 2E is a schematic cross-sectional view for explaining the other example of the method for producing a processed semiconductor substrate (part 5).
Fig. 2F is a schematic cross-sectional view for explaining the other example of the method for producing a processed semiconductor substrate (part 6).
Fig. 2G is a schematic cross-sectional view for explaining the other example of the method for producing a processed semiconductor substrate (part 7).
Fig. 2H is a schematic cross-sectional view for explaining the other example of the method for producing a processed semiconductor substrate (part 8).
Fig. 2I is a schematic cross-sectional view for explaining the other example of the method for producing a processed semiconductor substrate (part 9).
Fig. 2J is a schematic cross-sectional view for explaining the other example of the method for producing a processed semiconductor substrate (part 10).
Fig. 2K is a schematic cross-sectional view for explaining the other example of the method for producing a processed semiconductor substrate (part 11).

### Description of Embodiments

### (Composition for Forming Coating Film for Removing Foreign Matters)

A composition for forming a coating film for removing foreign matters of the present invention contains a polymer and a solvent.

Preferably, the composition for forming a coating film for removing foreign matters can form a coating film that can be removed with a removing liquid.

### <Polymer>

The polymer is a polymer containing a structure represented by Formula (1) below: 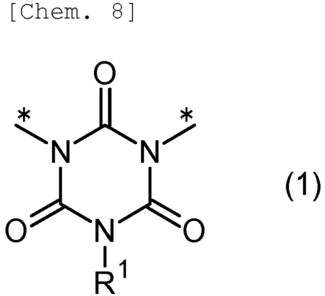 [In Formula (1), R¹ represents a hydrogen atom, a protecting group of an imide group deprotected by an alkali, or a protecting group of an imide group deprotected by an acid, and * represents a bond.]

Examples of the protecting group of an imide group that is deprotected by an alkali in R¹ include a methyl group, a cyclohexyl group, a hydroxyethyl group, a benzyl group, and a phenyl group.

Examples of the protecting group of an imide group deprotected by an acid in R¹ include a tert-butoxycarbonyl group, a benzyloxycarbonyl group, a trimethylsilyl group, a tert-butyldimethylsilyl group, a methoxymethyl group, an ethoxymethyl group, a tetrahydropyranyl group, an acetyl group, a benzyl group, and a p-methoxybenzyl group.

Examples of the alkali include alkalis contained in alkaline removing liquids.

Examples of the acid include acids contained in acidic removing liquids.

The deprotection of the protecting group of an imide group deprotected by the alkali can be performed, for example, when the coating film formed from the composition for forming a coating film for removing foreign matters is brought into contact with an alkaline removing liquid.

The deprotection of the protecting group of an imide group deprotected by the acid can be performed, for example, when the coating film formed from the composition for forming a coating film for removing foreign matters is brought into contact with an acidic removing liquid.

When a coating film is formed from a composition for forming a coating film for removing foreign matters containing an acid generator, the deprotection of the protecting group of an imide group deprotected by the acid can be performed, for example, using an acid generated from the acid generator.

The coating film prepared from the composition for forming a coating film for removing foreign matters exhibits good heat resistance owing to the polymer containing the structure represented by Formula (1).

In addition, the coating film prepared from the composition for forming a coating film for removing foreign matters can be removed with the removing liquid owing to the structure represented by Formula (1).

Accordingly, the composition for forming a coating film for removing foreign matters of the present invention is a composition that can prevent foreign matters from remaining on a substrate by a simple method and provide a coating film having heat resistance.

R¹ in Formula (1) is preferably a hydrogen atom.

The polymer preferably further contains a structure represented by Formula (2) below. 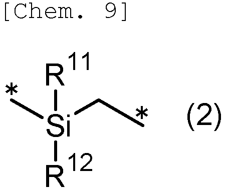 [In Formula (2), R¹¹ and R¹² each independently represent an optionally substituted alkyl group having 1 to 10 carbon atoms, an optionally substituted phenyl group, or an optionally substituted phenoxy group, and * represents a bond.]

Examples of the substituent in the optionally substituted alkyl group having 1 to 10 carbon atoms in the present invention include a halogen atom, a hydroxy group, and a carboxy group.

Examples of the halogen atom include a fluorine atom, a chlorine atom, an iodine atom, and a bromine atom.

Examples of the optionally substituted alkyl group having 1 to 10 carbon atoms include an alkyl group having 1 to 10 carbon atoms.

Examples of the substituents in the optionally substituted phenyl group and the optionally substituted phenoxy group in the present invention include a halogen atom, an alkyl group having 1 to 6 carbon atoms that may be substituted with a halogen atom, and an alkoxy group having 1 to 6 carbon atoms that may be substituted with a halogen atom.

The number of substituents in the phenyl group and the phenoxy group may be one or may be two or more.

When the number of substituents in the phenyl group and the phenoxy group is two or more, they may be the same kind of substituents or different kinds of substituents.

As R¹¹ and R¹² in Formula (2), an alkyl group having 1 to 10 carbon atoms is preferable, an alkyl group having 1 to 6 carbon atoms is more preferable, and a methyl group is particularly preferable.

For example, in the polymer, the structure represented by Formula (1) and the structure represented by Formula (2) are linked as in the structure represented by Formula (11) below. In other words, the polymer contains a structure represented by Formula (11) below: 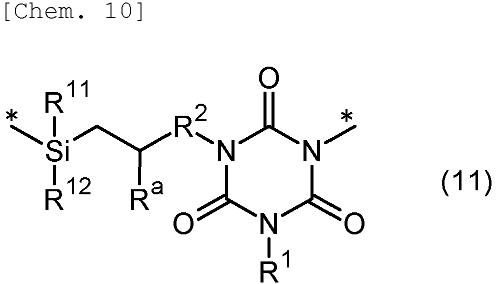
[In Formula (11), R¹ represents a hydrogen atom, a protecting group of an imide group deprotected by an alkali, or a protecting group of an imide group deprotected by an acid.
R² represents a divalent group having 1 to 6 carbon atoms.
R¹¹ and R¹² each independently represent an optionally substituted alkyl group having 1 to 10 carbon atoms, an optionally substituted phenyl group, or an optionally substituted phenoxy group.
R^{a} represents a hydrogen atom or a methyl group.
* represents a bond.]

Examples of R² in Formula (11) include a divalent group represented by Formula (L) below. 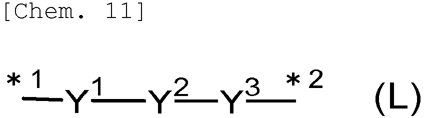
(In Formula (L), Y¹ represents a single bond or an alkylene group having 1 to 6 carbon atoms.
Y² represents a single bond, -C(=O)-, -O-, -C(=O)O-, -OC(=O)-, or -OCH₂CH(OH)-.
Y³ represents a single bond or an alkylene group having 1 to 6 carbon atoms.
   *1 represents a bond to a carbon atom.
   *2 represents a bond to a nitrogen atom.

However, the total number of carbon atoms of Y¹, Y², and Y³ is 1 to 6.)

Examples of the divalent group represented by Formula (L) include the following groups. 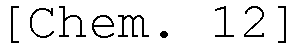 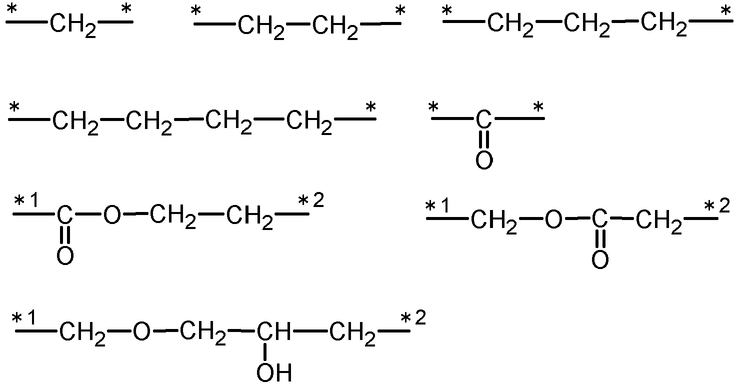 (In the formula, * represents a bond. *1 represents a bond to a carbon atom. *2 represents a bond to a nitrogen atom.)

Examples of the alkylene group having 1 to 6 carbon atoms in the present invention include a methylene group, a 1,2-ethylene group, a 1,3-propylene group, a 1,2-propylene group, a 1,4-butylene group, a 1,5-pentylene group, and a 1,6-hexylene group.

R² in Formula (11) is preferably a methylene group.

As R¹¹ and R¹² in Formula (11), an alkyl group having 1 to 10 carbon atoms and an optionally substituted phenyl group are preferable, an alkyl group having 1 to 6 carbon atoms and a phenyl group are more preferable, and a methyl group and a phenyl group are particularly preferable.

The polymer is preferably a polymer obtained by a hydrosilylation reaction between a compound having a Si-H group and a compound having a carbon-carbon unsaturated bond capable of a hydrosilylation reaction.

The hydrosilylation reaction is performed, for example, in the presence of a platinum group metal-based catalyst.

Such a platinum-based metal catalyst is a catalyst for promoting a hydrosilylation reaction between a Si-H group of a compound having a Si-H group and a carbon-carbon unsaturated bond (such as a carbon-carbon double bond) of a compound having a carbon-carbon unsaturated bond.

Specific examples of the platinum-based metal catalyst include, but are not limited to, platinum-based catalysts such as platinum black, platinic chloride, chloroplatinic acid, a reaction product of chloroplatinic acid and a monohydric alcohol, a complex of chloroplatinic acid and an olefin, and platinum bisacetoacetate.

Examples of the complex of platinum and an olefin include, but are not limited to, a complex (such as Karstedt's catalyst) of divinyltetramethyldisiloxane and platinum.

The amount of the platinum group metal-based catalyst in the hydrosilylation reaction is not particularly limited.

### <<Compound Having Si-H Group>>

The compound having a Si-H group is not particularly limited as long as it is a compound having at least one Si-H group.

The number of Si-H groups in the compound having a Si-H group may be one or may be two or more.

The compound having a Si-H group is preferably a compound represented by Formula (2A) below, a cyclic siloxane compound represented by Formula (2B) below, or a silsesquioxane having a Si-H group. 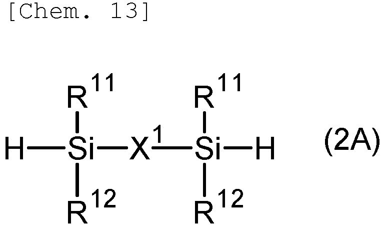 [In Formula (2A), R¹¹s and R¹²s each independently represent an optionally substituted alkyl group having 1 to 10 carbon atoms, an optionally substituted phenyl group, or an optionally substituted phenoxy group.

X¹ represents a single bond, an organic group having 1 to 10 carbon atoms, or a group represented by Formula (2A-1) below.] 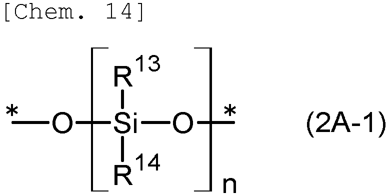 [In Formula (2A-1), R¹³ and R¹⁴ each independently represent an optionally substituted alkyl group having 1 to 10 carbon atoms, an optionally substituted phenyl group, or an optionally substituted phenoxy group. n represents an integer of 0 to 10. * represents a bond.] 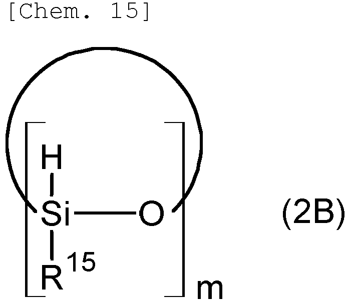 [In Formula (2B), R¹⁵ each independently represents an optionally substituted alkyl group having 1 to 10 carbon atoms, an optionally substituted phenyl group, or an optionally substituted phenoxy group. m represents an integer of 3 to 6.

As R¹¹ and R¹² in Formula (2A), an alkyl group having 1 to 10 carbon atoms and an optionally substituted phenyl group are preferable, an alkyl group having 1 to 6 carbon atoms and a phenyl group are more preferable, and a methyl group and a phenyl group are particularly preferable.

Examples of the organic group having 1 to 10 carbon atoms of X¹ in Formula (2A) include an alkylene group having 1 to 6 carbon atoms and a phenylene group.

As R¹³ and R¹⁴ in Formula (2A-1), an alkyl group having 1 to 10 carbon atoms and an optionally substituted phenyl group are preferable, an alkyl group having 1 to 6 carbon atoms and a phenyl group are more preferable, and a methyl group and a phenyl group are particularly preferable.

Examples of n in Formula (2A-1) include 0, 1, 2, 3, and 4.

Examples of the compound represented by Formula (2A) include the following compounds.

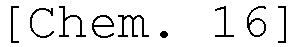

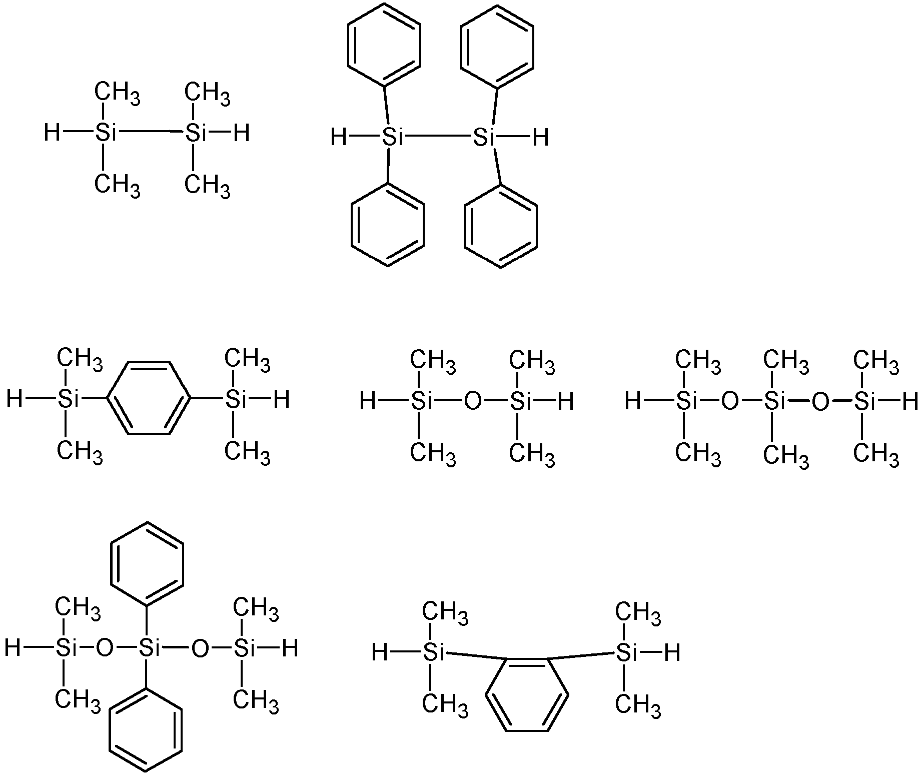

As R¹⁵ in Formula (2B), an alkyl group having 1 to 10 carbon atoms is preferable, an alkyl group having 1 to 6 carbon atoms is more preferable, and a methyl group is particularly preferable.

Examples of the cyclic siloxane compound represented by Formula (2B) include 2,4,6-trimethylcyclotrisiloxane, 2,4,6,8-tetramethylcyclotetrasiloxane, 2,4,6,8,10-pentamethylcyclopentasiloxane, 2,4,6,8,10,12-hexamethylcyclohexasiloxane, and 2,4,6,8,10,12,14-heptamethylcycloheptasiloxane.

2,4,6,8-Tetramethylcyclotetrasiloxane is represented by the following formula.

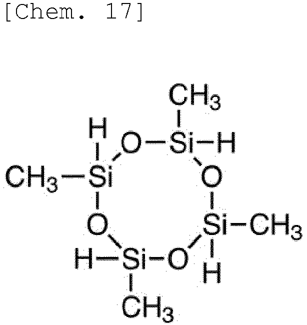

A silsesquioxane is a network type polymer or polyhedral cluster obtained by hydrolyzing a trifunctional silane. As the silsesquioxane, silsesquioxanes having a random structure, a ladder structure, and a cage structure are known.

Examples of the cage structure include a closed cage structure and an open cage structure.

The number of Si-H groups in the silsesquioxane having a Si-H group may be one or may be two or more.

Examples of the silsesquioxane having a Si-H group include cage-like silsesquioxanes represented by Formulas (SQ1) to (SQ7) below.

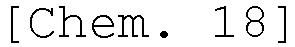

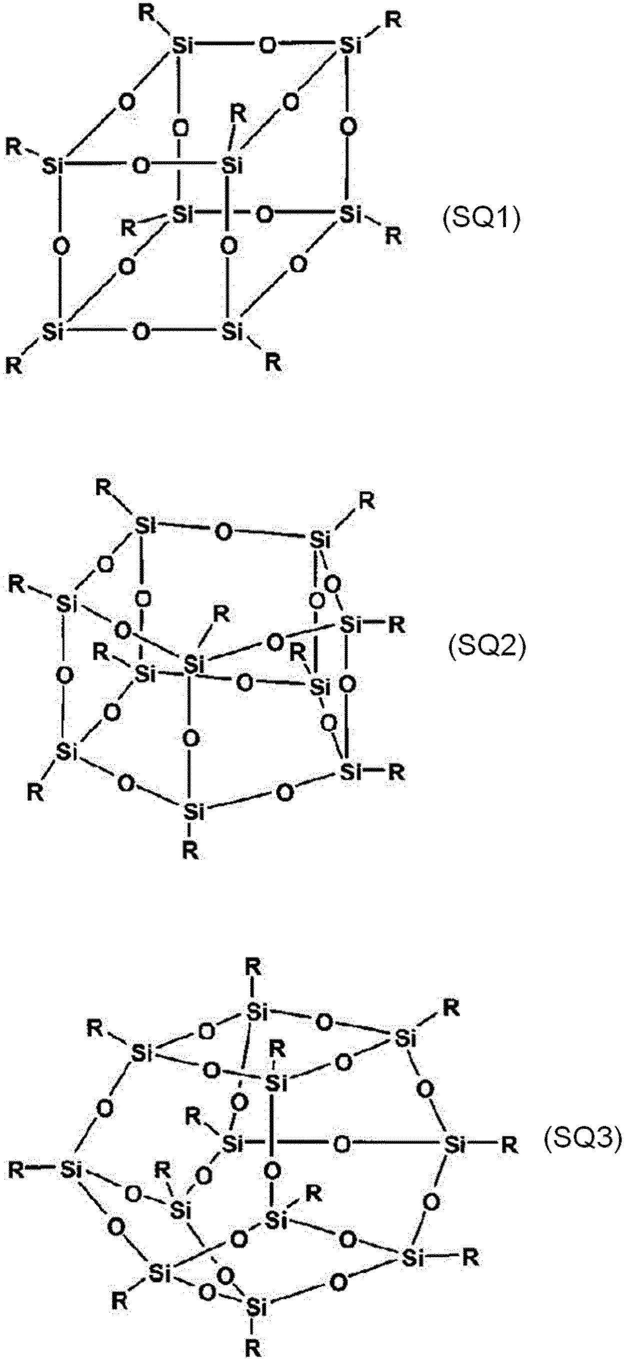

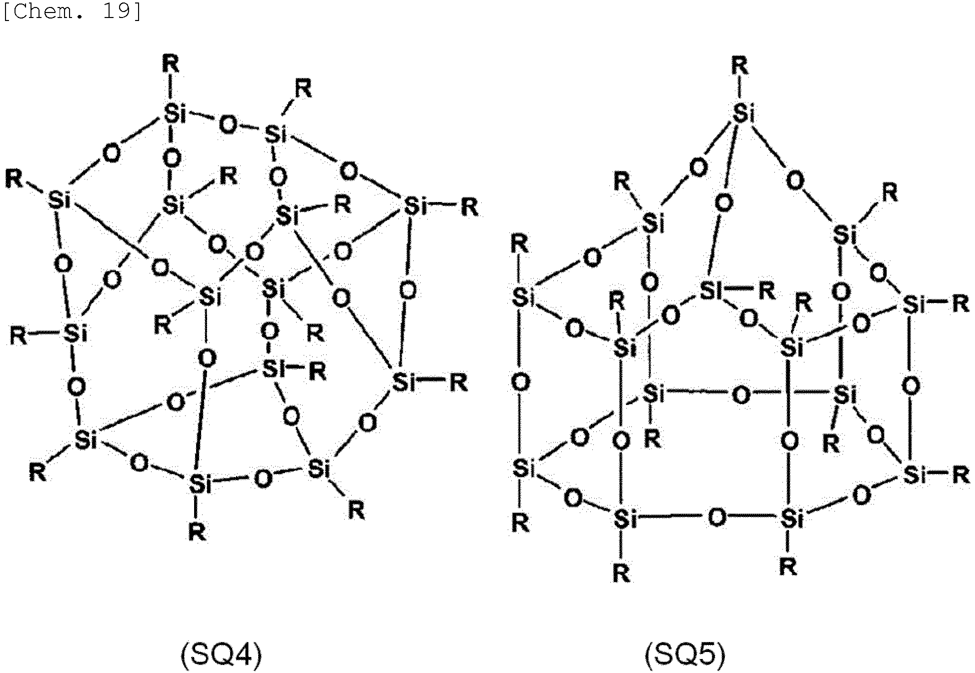

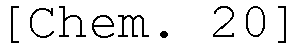

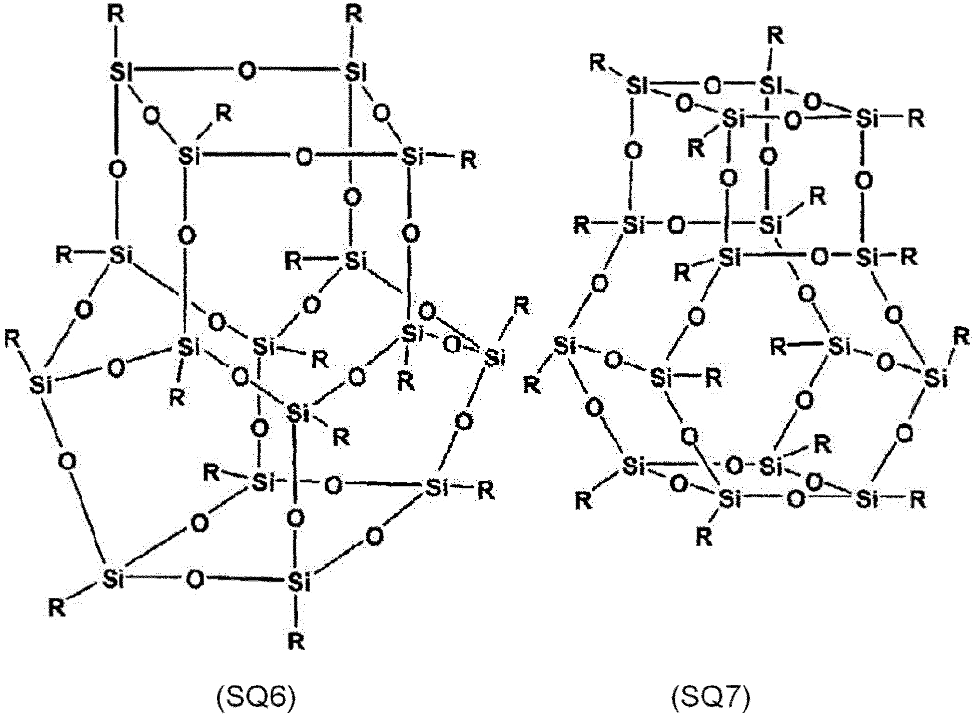

[In Formulas (SQ1) to (SQ7), Rs each independently represents a hydrogen atom, an alkyl group having 1 to 6 carbon atoms, a phenyl group, or -O-Si(R¹⁰¹)(R¹⁰²)H (R¹⁰¹ and R¹⁰² each independently represent an alkyl group having 1 to 6 carbon atoms or a phenyl group).

However, each of Formulas (SQ1) to (SQ7) has at least one Si-H group.]

Examples of the silsesquioxane having a Si-H group include the following compounds.

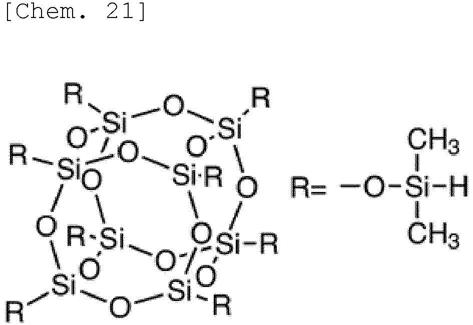

The molecular weight of the compound having a Si-H group is not particularly limited, but may be, for example, 100 to 1,500.

### <<Compound Having Carbon-Carbon Unsaturated Bond>>

The compound having a carbon-carbon unsaturated bond has a carbon-carbon unsaturated bond that can undergo a hydrosilylation reaction. Examples of the carbon-carbon unsaturated bond that can undergo a hydrosilylation reaction include a carbon-carbon double bond and a carbon-carbon triple bond.

The number of carbon-carbon unsaturated bonds that can undergo a hydrosilylation reaction in the compound having a carbon-carbon unsaturated bond is not particularly limited, but may be one or may be two or more.

The compound having a carbon-carbon unsaturated bond preferably includes a compound represented by Formula (1A) below.

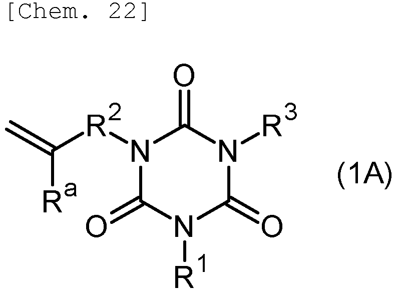

[In Formula (1A), R¹ represents a hydrogen atom, a protecting group of an imide group deprotected by an alkali, or a protecting group of an imide group deprotected by an acid.

R² represents a divalent group having 1 to 6 carbon atoms.

R³ represents a hydrogen atom, a protecting group of an imide group deprotected by an alkali, a protecting group of an imide group deprotected by an acid, or a group represented by Formula (1A-1) below.

R^{a} represents a hydrogen atom or a methyl group.] 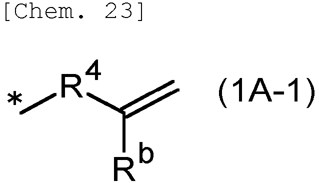 [In Formula (1A-1), R⁴ represents a divalent group having 1 to 6 carbon atoms. R^{b} represents a hydrogen atom or a methyl group. * represents a bond.]

Specific examples of the protecting group of an imide group deprotected by an alkali of R¹ and R³ in Formula (1A) include the specific examples of the protecting group of an imide group deprotected by an alkali of R¹ in Formula (1).

Specific examples of the protecting group of an imide group deprotected by an acid of R¹ and R³ in Formula (1A) include the specific examples of the protecting group of an imide group deprotected by an acid of R¹ in Formula (1).

Examples of R² in Formula (1A) include the divalent group represented by Formula (L) above.

Specific examples of R² in Formula (1A) include the specific examples mentioned in the description of R² in Formula (11).

Examples of R⁴ in Formula (1A-1) include the divalent group represented by Formula (L) above.

Specific examples of R⁴ in Formula (1A-1) include the specific examples mentioned in the description of R² in Formula (11).

R² in Formula (1A) is preferably a methylene group.

When R³ in Formula (1A) represents the group represented by Formula (1A-1), R⁴ in Formula (1A-1) is preferably a methylene group.

Examples of the compound represented by Formula (1A) include the following compounds.

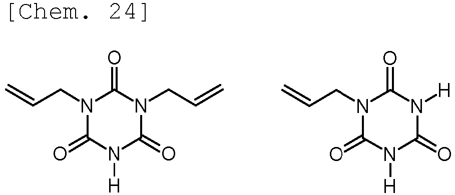

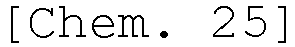

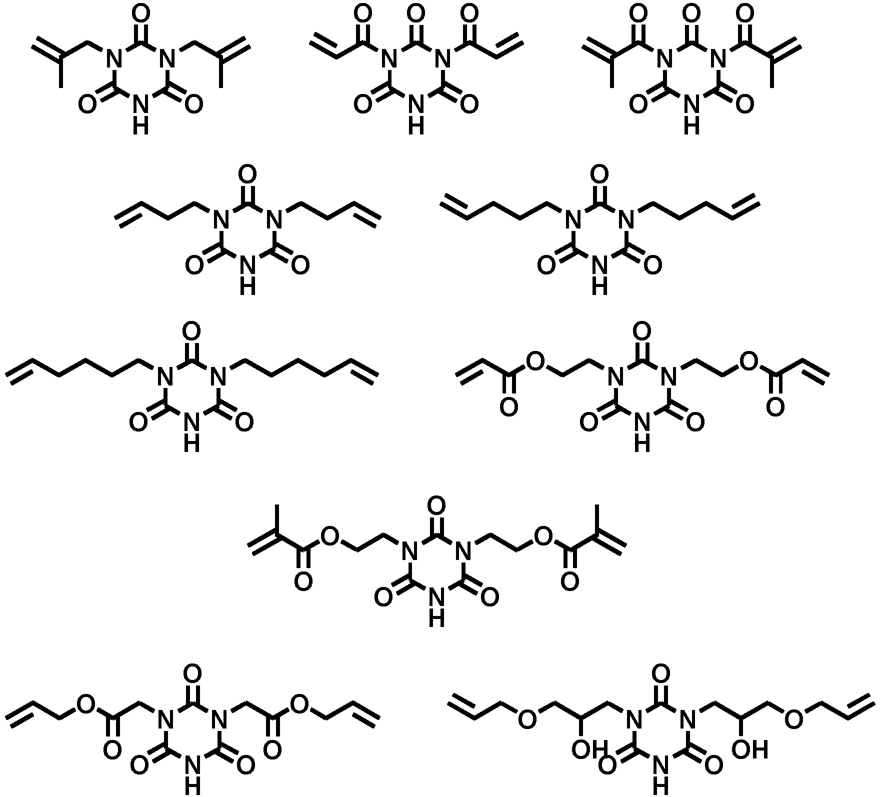

When a polymer is obtained using a hydrosilylation reaction, the compound having a carbon-carbon unsaturated bond may include a compound having a carbon-carbon unsaturated bond other than the compound represented by Formula (1A), in addition to the compound represented by Formula (1A).

Examples of the compound having a carbon-carbon unsaturated bond other than the compound represented by Formula (1A) include a compound represented by Formula (X) below. 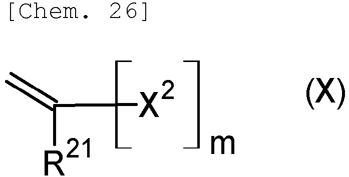 [In Formula (X), R²¹ represents a hydrogen atom or a methyl group.

X² represents an m-valent organic group.

m represents an integer of 1 to 3.

The molecular weight of X² in Formula (X) is not particularly limited, but is, for example, 100 to 500.

X² in Formula (X) does not have, for example, the following isocyanuric acid structure. 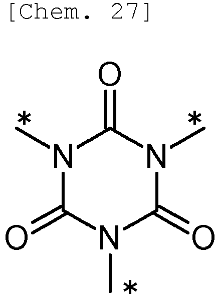 [In the formula, * represents a bond.]

The compound represented by Formula (X) preferably has no ester bond from the viewpoint of heat resistance of the polymer.

X² in Formula (X) preferably has an aromatic ring. The aromatic ring may be an aromatic hydrocarbon ring or may be an aromatic heterocyclic ring.

Examples of the compound represented by Formula (X) include a compound represented by Formula (X1) below. 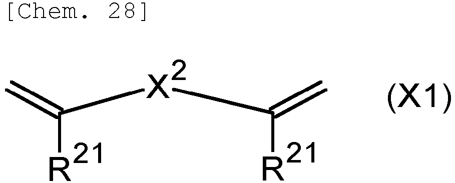 [In Formula (X1), R²¹s each independently represents a hydrogen atom or a methyl group.

X² represents a divalent organic group having an aromatic ring.]

Examples of the compound represented by Formula (X) include the following compounds.

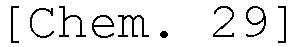

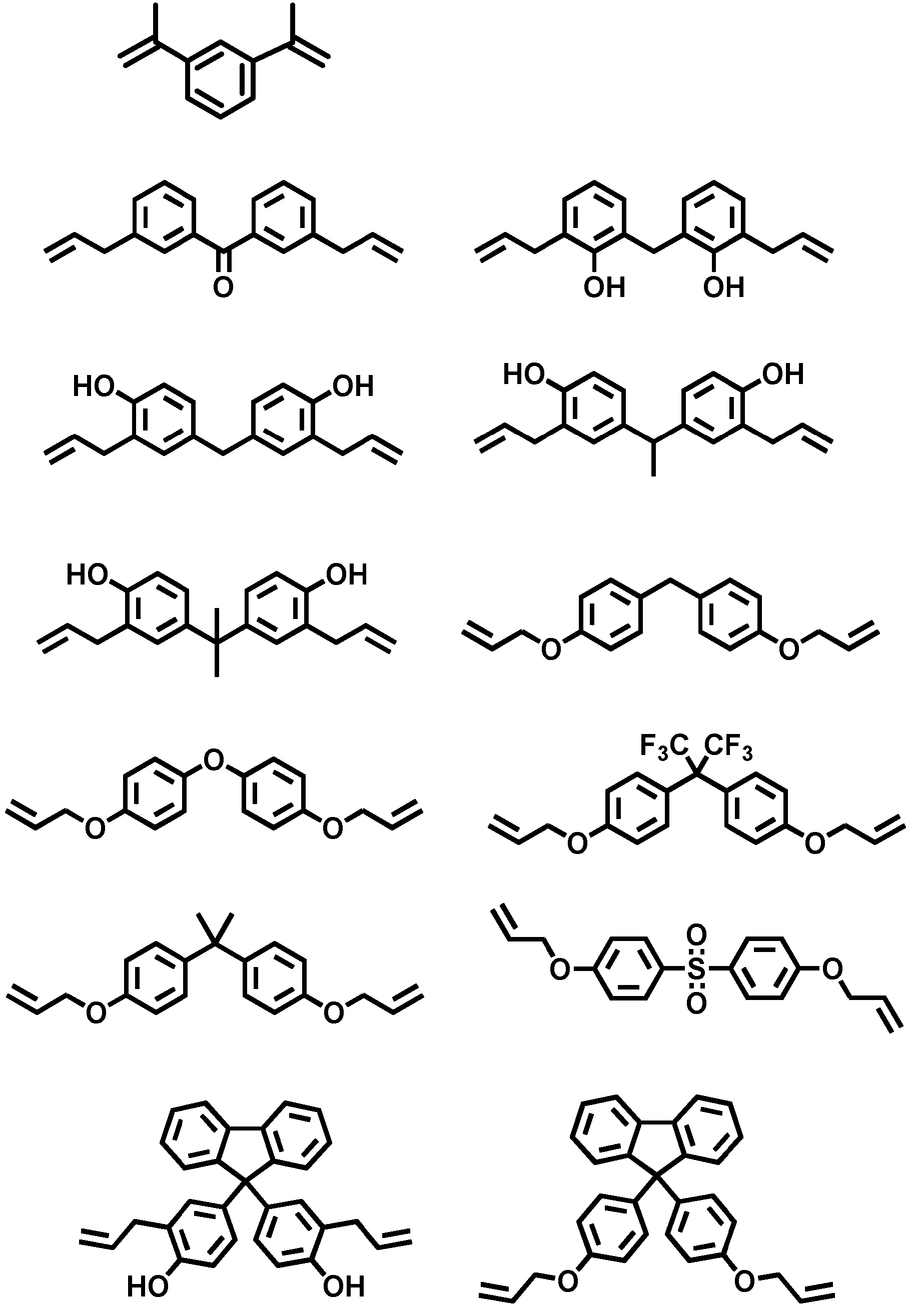

The polymer has, for example, a unit structure represented by Formula (Y) below.

The polymer having the unit structure represented by Formula (Y) is obtained, for example, by a hydrosilylation reaction between a compound having a Si-H group including the compound represented by Formula (2A) and a compound having a carbon-carbon unsaturated bond including the compound represented by Formula (1A).

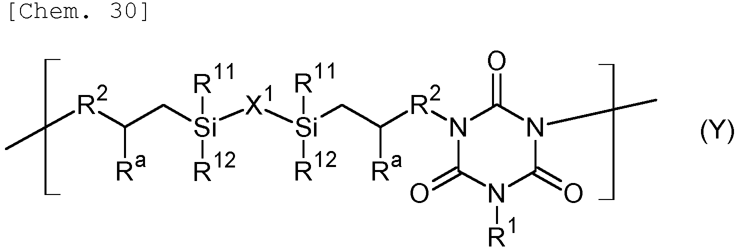

[In Formula (Y), R¹ represents a hydrogen atom, a protecting group of an imide group deprotected by an alkali, or a protecting group of an imide group deprotected by an acid.

R² represents a divalent group having 1 to 6 carbon atoms.

R¹¹s and R¹²s each independently represent an optionally substituted alkyl group having 1 to 10 carbon atoms, an optionally substituted phenyl group, or an optionally substituted phenoxy group.

R^{a} represents a hydrogen atom or a methyl group.]

R¹ in Formula (Y) is as defined for R¹ in Formulas (1) and (11).

R² in Formula (Y) is as defined for R² in Formula (11).

R¹¹, R¹², and X¹ in Formula (Y) are as defined for R¹¹ and R¹² in Formulas (2) and (2A) and X¹ in Formula (2A), respectively.

The weight-average molecular weight of the polymer is not particularly limited, and is preferably 1,000 to 50,000, more preferably 1,500 to 30,000. The weight-average molecular weight is a value obtained by gel permeation chromatography (GPC) using polystyrene as a standard sample.

The content of the polymer in the composition for forming a coating film for removing foreign matters is not particularly limited, and is preferably 0.01 mass% to 60 mass%, more preferably 0.1 mass% to 40 mass%, particularly preferably 0.5 mass% to 30 mass% relative to the solid content.

### <<Removing Liquid>>

The removing liquid is not particularly limited as long as it can remove the coating film formed from the composition for forming a coating film for removing foreign matters.

The coating film is formed on, for example, a semiconductor substrate. In this case, the removal refers to removal from the semiconductor substrate.

Here, examples of the mode of removal include dissolution removal and peeling removal. Examples of the peeling removal include peeling from an adherend by swelling.

The removing liquid may contain water or an organic solvent.

The removing liquid may be a removing liquid that contains an organic solvent in an amount of 50 mass% or more.

Examples of the organic solvent include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monomethyl ether acetate, propylene glycol propyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, N,N-dimethylformamide, N,N-dimethylacetamide, and N-methylpyrrolidone.

Examples of the removing liquid include an alkaline removing liquid and an acidic removing liquid.

The alkaline removing liquid contains an alkali. Examples of the alkali include ammonia, an inorganic alkaline compound, quaternary ammonium hydroxide, an amine, and hydrazine.

The alkaline removing liquid is a developer or a cleaning liquid used in a semiconductor production process, and may exhibit alkalinity. Examples of the developer include NMD-3 (2.38% tetramethylammonium hydroxide aqueous solution, manufactured by TOKYO OHKA KOGYO CO., LTD.).

Examples of the inorganic alkaline compound include potassium hydroxide, sodium hydroxide, lithium hydroxide, diammonium hydrogen phosphate, dipotassium hydrogen phosphate, disodium hydrogen phosphate, lithium silicate, sodium silicate, potassium silicate, lithium carbonate, sodium carbonate, potassium carbonate, lithium borate, sodium borate, and potassium borate.

Examples of the quaternary ammonium hydroxide include tetramethylammonium hydroxide, tetraethylammonium hydroxide, trimethylhydroxyethylammonium hydroxide, and choline.

Examples of the amine include ethanolamine, methylamine, dimethylamine, trimethylamine, monoethylamine, diethylamine, triethylamine, n-propylamine, di-n-propylamine, isopropylamine, diisopropylamine, methyldiethylamine, dimethylethanolamine, triethanolamine, and ethylenediamine.

Examples of the hydrazine include hydrazine monohydrate.

The alkaline removing liquid may be SC-1 (ammonia-hydrogen peroxide solution).

The acidic removing liquid contains an acid. Examples of the acid include an inorganic acid and an organic acid. Examples of the inorganic acid include sulfuric acid, nitric acid, hydrochloric acid, phosphoric acid, and hydrofluoric acid.

The acidic removing liquid is, for example, an aqueous solution containing dilute hydrofluoric acid.

The acidic removing liquid may be, for example, an aqueous solution containing sulfuric acid and hydrogen peroxide, or an aqueous solution containing acetic acid or a chelating agent. Examples of the chelating agent include organic acids, salts of organic acids, amino acids, and derivatives of amino acids.

### <Solvent>

Examples of the solvent to be used include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monomethyl ether acetate, propylene glycol propyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, N,N-dimethylformamide, N,N-dimethylacetamide, and N-methylpyrrolidone.

These solvents may be used singly or in combination of two or more kinds thereof.

Further, a high-boiling-point solvent such as propylene glycol monobutyl ether and propylene glycol monobutyl ether acetate can be mixed and used.

The composition for forming a coating film for removing foreign matters can be easily prepared, for example, by uniformly mixing the respective components, and is dissolved in an appropriate solvent and used in a solution state.

Preferably, the composition for forming a coating film for removing foreign matters thus prepared is filtered using a filter having a pore size of about 0.2 µm or the like and then used. The composition for forming a coating film for removing foreign matters thus prepared is also excellent in long-term storage stability at room temperature.

The ratio of the solid content in the composition for forming a coating film for removing foreign matters is not particularly limited as long as the components are uniformly dissolved. The ratio is, for example, 0.5 to 50 mass%, or, for example, 1 to 30 mass%. Here, the solid content means a component left after removal of the solvent component from all the components of the composition for forming a coating film for removing foreign matters.

In the present invention, the foreign matters mean materials that are deposited on the substrate but are other than the intended material. In the semiconductor device production, the foreign matters are unnecessary materials. Examples of the foreign matters include particles deposited on the wafer, metal impurities, etching residues, and peeled residues of the adhesive layer.

The coating film for removing foreign matters is particularly preferably used, in the step of bonding wafers using an adhesive, and then peeling off the adhesive, in order to form the coating film of the present invention before applying the adhesive, and conduct wafer bonding and peeling steps, and then peel off foreign matters (residue of the adhesive layer).

The coating film for removing foreign matters can also be used to remove pre-existing foreign matters on a semiconductor substrate.

The expression that the coating film for removing foreign matters is soluble in a removing liquid means that when the coating film is immersed in the removing liquid, cleaned with the removing liquid, or the like, the coating film is dissolved in the removing liquid, so it is not present on an adherend such as a substrate. The term "dissolved (or dissolution)" in the present invention means that at least 90% or more of the thickness of the film originally formed is removed (i.e. the thickness of the residual film is 10% or less that of the original film); or at least 95% or more of the thickness of the original film is removed (i.e. the thickness of the residual film is 5% or less that of the original film); or at least 99% or more of the thickness of the original film is removed (i.e. the thickness of the residual film is 1% or less that of the original film), and most preferably 100% of the thickness of the original film is removed (i.e. the thickness of the residual film is 0% of the thickness of the original film (no residual film remains)), from the film formed on the substrate.

Preferably, the composition contains at least one of a crosslinking agent and an additive.

### <Crosslinking Agent>

The crosslinking agent preferably contains an epoxy group.

The crosslinking agent may contain a compound having at least two epoxy groups. Such a compound is not particularly limited as long as it is a compound having epoxy groups. Examples of the compound include tris(2,3-epoxypropyl) isocyanurate, 1,4-butanediol diglycidyl ether, 1,2-epoxy-4-(epoxyethyl)cyclohexane, glycerol triglycidyl ether, diethylene glycol diglycidyl ether, 2,6-diglycidyl phenyl glycidyl ether, 1,1,3-tris[p-(2,3-epoxypropoxy)phenyl]propane, 1,2-cyclohexanedicarboxylic acid diglycidyl ester, 4,4'-methylenebis(N,N-diglycidylaniline), 3,4-epoxycyclohexylmethyl-3,4-epoxycyclohexanecarboxylate, trimethylolethane triglycidyl ether, bisphenol-A-diglycidyl ether, and pentaerythritol polyglycidyl ether.

Examples of the compound having at least two epoxy groups include compounds described below.

Examples of epoxy resins having an amino group include YH-434 and YH434L (trade names, manufactured by NIPPON STEEL Chemical & Material Co., Ltd.).

Examples of epoxy resins having a cyclohexene oxide structure include Epolead GT-401, Epolead GT-403, Epolead GT-301, Epolead GT-302, Celloxide 2021, and Celloxide 3000 (trade names, manufactured by Daicel Corporation).

Examples of bisphenol A type epoxy resins include Epikote 1001, Epikote 1002, Epikote 1003, Epikote 1004, Epikote 1007, Epikote 1009, Epikote 1010, and Epikote 828 (trade names, each of which is manufactured by Yuka Shell Epoxy Co., Ltd.).

Examples of bisphenol F type epoxy resins include Epikote 807 (trade name, manufactured by Yuka Shell Epoxy Co., Ltd.).

Examples of phenol novolac type epoxy resins include Epikote 152 and Epikote 154 (trade names, each of which is manufactured by Yuka Shell Epoxy Co., Ltd.), and EPPN201 and EPPN202 (trade names, each of which is manufactured by Nippon Kayaku Co., Ltd.).

Examples of cresol novolac type epoxy resins include EOCN-102, EOCN-103S, EOCN-104S, EOCN-1020, EOCN-1025, EOCN-1027 (trade names, each of which is manufactured by Nippon Kayaku Co., Ltd.), and Epikote 180 S75 (trade name, manufactured by Yuka Shell Epoxy Co., Ltd.).

Examples of alicyclic epoxy resins include Denacol EX-252 (trade name, manufactured by Nagase ChemteX Corporation), CY175, CY177, CY179 (trade names, each of which is manufactured by CIBA-GEIGY AG), Araldite CY-182, Araldite CY-192, Araldite CY-184 (trade names, each of which is manufactured by CIBA-GEIGY AG), EPICLON 200, EPICLON 400 (trade names, each of which is manufactured by Dainippon Ink and Chemicals, Inc.), Epikote 871, Epikote 872 (trade names, each of which is manufactured by Yuka Shell Epoxy Co., Ltd.), ED-5661, and ED-5662 (trade names, each of which is manufactured by Celanese Coating Co.).

Examples of aliphatic polyglycidyl ethers include Denacol EX-611, Denacol EX-612, Denacol EX-614, Denacol EX-622, Denacol EX-411, Denacol EX-512, Denacol EX-522, Denacol EX-421, Denacol EX-313, Denacol EX-314, and Denacol EX-321 (trade names, manufactured by Nagase ChemteX Corporation).

The content of the compound having at least two epoxy groups is, for example, 5 to 70 parts by mass, or 10 to 60 parts by mass, preferably 15 to 45 parts by mass, relative to 100 parts by mass of the polymer. The content of the compound having at least two epoxy groups is preferably 5 parts by mass or more relative to 100 parts by mass of the polymer from the viewpoint of the degree of cure of the coating film and prevention of intermixing with the adhesive layer, and is preferably 70 parts by mass or less relative to 100 parts by mass of the polymer from the viewpoint of the solubility in the removing liquid.

### <Additive>

The composition for forming a coating film for removing foreign matters may contain, as additives, a light-absorbing compound, a surfactant, an adhesion aid, a rheology controlling agent, and silica particles.

The light-absorbing compound is not particularly limited as long as it is a compound having absorption at a wavelength of light used in exposure. A compound having an aromatic ring structure, such as an anthracene ring, a naphthalene ring, a benzene ring, a quinoline ring, and a triazine ring, is preferably used. From the viewpoint of not inhibiting the solubility of the coating film for removing foreign matters in a removing liquid, a compound having a phenolic hydroxy group, a carboxy group, or a sulfonic acid group is preferably used.

Examples of the light-absorbing compound having an intense absorption to light having a wavelength of 248 nm include 1-naphthalenecarboxylic acid, 2-naphthalenecarboxylic acid, 1-naphthol, 2-naphthol, 1-aminonaphthalene, 1-hydroxy-2-naphthalenecarboxylic acid, 3-hydroxy-2-naphthalenecarboxylic acid, 3,7-dihydroxy-2-naphthalenecarboxylic acid, 6-bromo-2-hydroxynaphthalene, 1,2-naphthalenedicarboxylic acid, 1,3-naphthalenedicarboxylic acid, 1,4-naphthalenedicarboxylic acid, 1,5-naphthalenedicarboxylic acid, 1,6-naphthalenedicarboxylic acid, 1,7-naphthalenedicarboxylic acid, 1,8-naphthalenedicarboxylic acid, 2,3-naphthalenedicarboxylic acid, 2,6-naphthalenedicarboxylic acid, 1,2-dihydroxynaphthalene, 1,3-dihydroxynaphthalene, 1,4-dihydroxynaphthalene, 1,5-dihydroxynaphthalene, 1,6-dihydroxynaphthalene, 1,7-dihydroxynaphthalene, 1,8-dihydroxynaphthalene, 2,3-dihydroxynaphthalene, 2,6-dihydroxynaphthalene, 2,7-dihydroxynaphthalene, 6-hydroxy-1-naphthalenecarboxylic acid, 1-hydroxy-2-naphthalenecarboxylic acid, 3-hydroxy-2-naphthalenecarboxylic acid, 6-hydroxy-2-naphthalenecarboxylic acid, 1-bromo-2-hydroxy-3-naphthalenecarboxylic acid, 1-bromo-4-hydroxy-3-naphthalenecarboxylic acid, 1,6-dibromo-2-hydroxy-3-naphthalenecarboxylic acid, 3-hydroxy-7-methoxy-2-naphthalenecarboxylic acid, 1-amino-2-naphthol, 1,5-dimercaptonaphthalene, 1,4,5,8-naphthalenetetracarboxylic acid, 3,5-dihydroxy-2-naphthalenecarboxylic acid, 1,4-dihydroxy-2-naphthalenecarboxylic acid, 2-ethoxy-1-naphthalenecarboxylic acid, 2,6-dichloro-1-naphthol, methyl 2-hydroxy-3-naphthalenecarboxylate, methyl 6-hydroxy-2-naphthalenecarboxylate, methyl 3-hydroxy-7-methoxy-2-naphthalenecarboxylate, methyl 3,7-dihydroxy-2-naphthalenecarboxylate, 2,4-dibromo-1-naphthol, 1-bromo-2-naphthol, 2-naphthalenethiol, 4-methoxy-1-naphthol, 6-acetoxy-2-naphthalenecarboxylic acid, 1,6-dibromo-1-naphthol, 2,6-dibromo-1,5-dihydroxynaphthalene, 1-acetyl-2-naphthol, 9-anthracenecarboxylic acid, 1,4,9,10-tetrahydroxyanthracene, and 1,8,9-trihydroxyanthracene.

Examples of the light-absorbing compound having a large absorption for light having a wavelength of 193 nm include benzoic acid, 4-methylbenzoic acid, o-phthalic acid, m-phthalic acid, p-phthalic acid, 2-methoxybenzoic acid, isophthalic acid, terephthalic acid, 2-hydroxybenzoic acid, 3-hydroxybenzoic acid, 4-hydroxybenzoic acid, 2-acetoxybenzoic acid, 2-aminobenzoic acid, 3-aminobenzoic acid, 4-aminobenzoic acid, trimesic acid, 1,4-benzenedicarboxylic acid, 2,3-dimethoxybenzoic acid, 2,4-dimethoxybenzoic acid, 2,5-dimethoxybenzoic acid, 2,4-dihydroxybenzoic acid, 2,6-dihydroxybenzoic acid, 3,4-dihydroxybenzoic acid, 3,5-dihydroxybenzoic acid, 4-acetyl benzoic acid, pyromellitic acid, trimesic anhydride, 2-s[bis-(4-hydroxyphenyl)-methyl]benzoic acid, 3,4,5-trihydroxybenzoic acid, 2-benzophenone carboxylic acid, m-phenylbenzoic acid, 3-(4'-hydroxyphenoxy)benzoic acid, 3-phenoxybenzoic acid, phenol, 1,4-dihydroxybenzene, 1,3-dihydroxybenzene, 1,2-dihydroxybenzene, 2-methylphenol, 3-methylphenol, 4-methyphenol, 1,3,5-trihydroxybenzene, 2,2-bis-4-hydroxyphenylpropane, 2-hydroxybiphenyl, 2-aminophenol, 3-aminophenol, 4-aminophenol, and 4-benzyloxyphenol.

To suppress the sublimation during the baking process for forming the coating film for removing foreign matters, the light-absorbing compound may be allowed to react with a polymer or a compound having one or more reactive groups before use.

For example, in the case of a light-absorbing compound having a carboxy group or a phenolic hydroxy group, there may be used a compound prepared by allowing the light-absorbing compound to react with a multifunctional epoxy compound such as tris(2,3-epoxypropyl) isocyanurate, 1,4-butanediol diglycidyl ether, 1,2-epoxy-4-(epoxyethyl)cyclohexane, glycerol triglycidyl ether, diethylene glycol diglycidyl ether, 2,6-diglycidyl phenyl glycidyl ether, 1,1,3-tris[p-(2,3-epoxypropoxy)phenyl]propane, 1,2-cyclohexanedicarboxylic acid diglycidyl ester, 4,4'-methylenebis(N,N-diglycidyl aniline), 3,4-epoxycyclohexylmethyl-3,4-epoxycyclohexanecarboxylate, trimethylolethane triglycidyl ether, bisphenol-A-diglycidyl ether, and pentaerythritol polyglycidyl ether, or with a polymer containing a structure having epoxy groups such as glycidyl methacrylate.

The above light-absorbing compounds can be used singly or in combination of two or more kinds thereof. When a light-absorbing compound is used, the content of the light-absorbing compound is, for example, 1 to 300 parts by mass or 1 to 200 parts by mass, and is, for example, 1 to 100 parts by mass or 5 to 100 parts by mass, relative to 100 parts by mass of the polymer. When the content of the light-absorbing compound is 300 parts by mass or less relative to 100 parts by mass of the polymer, the solubility of the coating film for removing foreign matters in a removing liquid is excellent, or intermixing of the coating film for removing foreign matters with the adhesive layer is less likely to be caused.

The composition for forming a coating film for removing foreign matters may contain an acid generator. Examples of the acid generator include thermal acid generators such as 2,4,4,6-tetrabromocyclohexadienone, benzoin tosylate, 2-nitrobenzyl tosylate, and other organic sulfonic acid alkyl esters, and photoacid generators, such as bis(4-tert-butylphenyl)iodonium trifluoromethanesulfonate, triphenylsulfonium trifluoromethanesulfonate, phenyl-bis(trichloromethyl)-s-triazine, benzoin tosylate, and N-hydroxysuccinimide trifluoromethanesulfonate. The amount of the acid generator added is, for example, 10 mass% or less, preferably 3 mass% or less based on the solid content of the composition for forming a coating film for removing foreign matters, and the acid generator is used, if necessary.

To the composition for forming a coating film for removing foreign matters, a polyhydric phenol compound or a carboxy group-containing compound may be added for the purpose of increasing the dissolution rate in the removing liquid. Such a compound is not particularly limited, and examples thereof include polyhydric phenols, such as tris-hydroxyphenylethane, bisphenol-A, bisphenol-S, 4,4'-isopropylidene-di-o-cresol, 5-tert-butylpyrogallol, hexafluorobisphenol-A, 3,3,3',3'-tetramethyl-1,1'-spirobisindan-5,5',6,6'-tetrol, 4,4'-(9-fluorenylidene)diphenol, bisphenol-AP, bisphenol-P, 5-α,α-dimethyl-4-hydroxybenzylsalicylic acid, α,α,α'-tris(4-hydroxyphenyl)-1-ethyl-4-isopropylbenzene, 5,5'-di-tert-butyl-2,2',4,4'-tetrahydroxybenzophenone; polycarboxylic acids, such as pyromellitic acid, phthalic acid, trimellitic acid, 4-sulfophthalic acid, benzenehexacarboxylic acid, 2,3-naphthalenedicarboxylic acid, 4-hydroxyphthalic acid, 3,4-dihydroxyphthalic acid, 4,5-dihydroxyphthalic acid, 3,3'-,4,4'-biphenyltetracarboxylic acid, 3,3'-,4,4'-benzophenonetetracarboxylic acid, 3,3'-,4,4'-diphenyl ether tetracarboxylic acid, 3,3'-,4,4'-diphenyl sulfone tetracarboxylic acid, 1,2,3,4-cyclobutanetetracarboxylic acid, 1,2-dimethyl-1,2,3,4-cyclobutanetetracarboxylic acid, 1,2,3,4-tetramethyl-1,2,3,4-cyclobutanetetracarboxylic acid, 1,2,3,4-cyclopentanetetracarboxylic acid, 1,2,3,4-cyclohexanetetracarboxylic acid, and 3,4-dicarboxy-1,2,3,4-tetrahydro-1-naphthalenesuccinic acid; and carboxylic acid- or carboxylic anhydride-containing polymers, such as polyacrylic acid, polymethacrylic acid, polyamic acid, and polymaleic anhydride. The above amount of the compound added is, for example, 20 mass% or less, preferably 10 mass% or less based on the solid content of the composition for forming a coating film for removing foreign matters, and the compound is used, if necessary.

For the purpose of controlling the dissolution rate in the removing liquid, a compound having a carboxy group or phenolic hydroxy group protected by a group that is readily decomposed in the presence of an acid, such as a tert-butyl group, a tetrahydropyranyl group, a 1-ethoxyethyl group, and a trimethylsilyl group, may also be added to the composition for forming a coating film for removing foreign matters.

Examples of the compound include compounds such as di-tert-butyl malonate, tert-butyl acetate, tert-butyl propionate, tert-butyl acetoacetate, tert-amyl acetate, benzoic acid-tert-butyl ester, and tert-butyl pivalate.

These compounds easily form a carboxy group or a phenolic hydroxy group in the presence of an acid, thereby providing a compound having an increased solubility in an alkaline removing liquid.

Accordingly, each of these compounds is preferably added to the composition for forming a coating film for removing foreign matters, together with a photoacid generator. That is, with regard to the coating film for removing foreign matters formed from the composition for forming a coating film for removing foreign matters containing the above-described compound having a carboxy group or phenolic hydroxy group protected by a group that is easily decomposed in the presence of an acid and a photoacid generator, the acid generated from the photoacid generator due to the exposure in the exposed region of the coating film for removing foreign matters regenerates the carboxy group or phenolic hydroxy group of the compound having a carboxy group or phenolic hydroxy group protected by a group that is easily decomposed in the presence of an acid. As the result, the solubility of the exposed area of the coating film for removing foreign matters in an alkaline removing liquid is increased.

When the above-described compound having a carboxy group or phenolic hydroxy group protected by a group that is easily decomposed in the presence of an acid is used, the content of the compound is, for example, 50 to 1 parts by mass, or 30 to 5 parts by mass, or, for example, 20 to 10 parts by mass, relative to 100 parts by mass of the polymer. When a photoacid generator is used together with the compound having a carboxy group or phenolic hydroxy group protected by a group that is easily decomposed in the presence of an acid, the content of the photoacid generator is, for example, 0.1 to 30 parts by mass, or 0.5 to 20 parts by mass, or, for example, 1 to 10 parts by mass, relative to 100 parts by mass of the compound having a carboxy group or phenolic hydroxy group protected by a group that is easily decomposed in the presence of an acid.

The composition for forming a coating film for removing foreign matters may contain a surfactant. Specific examples of the surfactant include nonionic surfactants, for example, polyoxyethylene alkyl ethers, such as polyoxyethylene lauryl ether, polyoxyethylene stearyl ether, polyoxyethylene cetyl ether, and polyoxyethylene oleyl ether, polyoxyethylene alkylallyl ethers, such as polyoxyethylene octylphenol ether and polyoxyethylene nonylphenol ether, polyoxyethylene-polyoxypropylene block copolymers, sorbitan fatty acid esters, such as sorbitan monolaurate, sorbitan monopalmitate, sorbitan monostearate, sorbitan monooleate, sorbitan trioleate, and sorbitan tristearate, polyoxyethylene sorbitan fatty acid esters, such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants, such as EFTOP EF301, EF303, and EF352 (trade names, manufactured by Tohkem Products Corporation), MEGAFACE F171 and F173 (trade names, manufactured by DIC Corporation), Fluorad FC430 and FC431 (trade names, manufactured by Sumitomo 3M Limited), AsahiGuard AG710 and SURFLON S-382, SC101, SC102, SC103, SC104, SC105, and SC106 (trade names, manufactured by AGC Inc.); and Organosiloxane Polymer KP341 (trade name, manufactured by Shin-Etsu Chemical Co., Ltd.). The amount of these surfactants is ordinarily 0.2 mass% or less, preferably 0.1 mass% or less relative to the total mass of all the components of the composition for forming a coating film for removing foreign matters. These surfactants may be added singly, or may be added in combination of two or more thereof.

The composition for forming a coating film for removing foreign matters may contain silica particles. Examples of the silica particles include a silicone powder having a predetermined mean particle size and a silica sol containing silica having a predetermined mean particle size.

Specific examples of the silicone powder include, but are not limited to, Silicone Powder KMP series KMP-600, KMP-601, KMP-602, KMP-605, and X-52-7030 (manufactured by Shin-Etsu Chemical Co., Ltd.).

Specific examples of the colloidal silica (silica sol) include, but are not limited to, MA-ST-S (silica sol dispersed in methanol), MT-ST (silica sol dispersed in methanol), MA-ST-UP (silica sol dispersed in methanol), trade name MA-ST-M (silica sol dispersed in methanol), MA-ST-L (silica sol dispersed in methanol), IPA-ST-S (silica sol dispersed in isopropanol), IPA-ST (silica sol dispersed in isopropanol), IPA-ST-UP (silica sol dispersed in isopropanol), IPA-ST-L (silica sol dispersed in isopropanol), IPA-ST-ZL (silica sol dispersed in isopropanol), NPC-ST-30 (silica sol dispersed in n-propyl cellosolve), PGM-ST (silica sol dispersed in 1-methoxy-2-propanol), DMAC-ST (silica sol dispersed in dimethylacetamide), XBA-ST (silica sol dispersed in xylene-n-butanol solvent mixture), trade name EAC-ST (silica sol dispersed in ethyl acetate), PMA-ST (silica sol dispersed in propylene glycol monomethyl ether acetate), MEK-ST (silica sol dispersed in methyl ethyl ketone), MEK-ST-UP (silica sol dispersed in methyl ethyl ketone), MEK-ST-L (silica sol dispersed in methyl ethyl ketone), and MIBK-ST (silica sol dispersed in methyl isobutyl ketone) (all manufactured by Nissan Chemical Corporation).

### (Coating Film for Removing Foreign Matters)

The coating film for removing foreign matters of the present invention is formed from the composition for forming a coating film for removing foreign matters of the present invention.

Preferably, a film thickness of the coating film for removing foreign matters of the present invention decreases by 5% or less when the coating film is heated at 250°C for 10 minutes in a nitrogen atmosphere.

The coating film for removing foreign matters of the present invention can be formed, for example, in the following manner.

The composition for forming a coating film for removing foreign matters of the present invention is applied onto a semiconductor substrate by an appropriate application method, such as methods using a spinner, a coater, and immersion, and then baked to form a coating film for removing foreign matters. The baking conditions are appropriately selected from a baking temperature of 80°C to 300°C, and a baking time of 0.3 to 60 minutes.

The film thickness of the coating film for removing foreign matters is ordinarily 5 nm to 1 µm, preferably 10 nm to 500 nm, most preferably 15 nm to 300 nm.

The dissolution rate of the coating film for removing foreign matters to be formed in a removing liquid indicated by the rate of decrease in film thickness is, for example, 0.1 nm to 50 nm per second, preferably 0.2 nm to 40 nm per second, more preferably 0.3 to 20 nm. When the dissolution rate is lower than this range, the time required to remove the coating film for removing foreign matters becomes long, leading to deterioration of productivity.

In the coating film for removing foreign matters formed from the composition for forming a coating film for removing foreign matters of the present invention, the dissolution rate of the coating film for removing foreign matters in a removing liquid can be controlled by changing the baking conditions for the formation of the film. As the baking temperature is increased at a constant baking time, a coating film for removing foreign matters having a smaller dissolution rate in a removing liquid can be formed.

The coating film for removing foreign matters may be exposed to light after the film is formed. The surface of a wafer may be fully exposed to light, or may be exposed through a mask having a predetermined pattern. The light exposure may be performed using a KrF excimer laser (wavelength: 248 nm), an ArF excimer laser (wavelength: 193 nm), an F2 excimer laser (wavelength: 157 nm), or the like. After the light exposure, post exposure bake (PEB) may be performed as necessary.

### (Semiconductor Substrate)

The semiconductor substrate of the present invention has the coating film for removing foreign matters of the present invention thereon.

The main material constituting the entire semiconductor substrate is not particularly limited as long as the material is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface, and for example, the outer periphery of the semiconductor substrate may have a linear portion called an orientation flat or may have a cut called a notch.

The thickness of the disk-shaped semiconductor substrate may be appropriately determined depending on the purpose of use of the semiconductor substrate and the like, and is not particularly limited, but is, for example, 500 to 1,000 µm.

The diameter of the disk-shaped semiconductor substrate may be appropriately determined depending on the purpose of use of the semiconductor substrate and the like, and is not particularly limited, but is, for example, 100 to 1,000 mm.

The semiconductor substrate may have a bump. The bump is a protruding terminal.

When the semiconductor substrate has a bump, the semiconductor substrate has the bump on the support base material side.

In the semiconductor substrate, the bump is usually formed on a surface on which a circuit is formed. The circuit may be a single layer or a multilayer. The shape of the circuit is not particularly limited.

In the semiconductor substrate, a surface (back surface) opposite to the surface having the bump is a surface to be processed.

The material, size, shape, structure, and density of the bump of the semiconductor substrate are not particularly limited.

Examples of the bump include a ball bump, a printed bump, a stud bump, and a plating bump.

Usually, the height, radius, and pitch of the bump are appropriately determined from the conditions of a bump height of approximately 1 to 200 µm, a bump radius of 1 to 200 µm, and a bump pitch of 1 to 500 µm.

Examples of the material of the bump include low melting point solder, high melting point solder, tin, indium, gold, silver, and copper. The bump may be composed of only a single component or may be composed of a plurality of components. More specific examples thereof include alloy plate mainly containing Sn, such as SnAg bumps, SnBi bumps, Sn bumps, and AuSn bumps.

In addition, the bump may have a laminated structure including a metal layer made of at least one of these components.

An example of the semiconductor substrate is a silicon wafer having a diameter of about 300 mm and a thickness of about 770 µm.

### (Method for Producing Processed Semiconductor Substrate)

### <First Embodiment>

A first embodiment of the method for producing a processed semiconductor substrate of the present invention includes a first A step, a second A step, a third A step, and a fourth A step.

The first A step is a step of producing a laminate by bonding the semiconductor substrate of the present invention (semiconductor substrate having the coating film for removing foreign matters of the present invention) to a support base material with the coating film for removing foreign matters interposed therebetween.

The second A step is a step of processing the laminate.

The third A step is a step of peeling off the support base material from the laminate.

The fourth A step is a step of cleaning the semiconductor substrate or the support base material with a removing liquid to remove the coating film for removing foreign matters.

In the first embodiment, the coating film for removing foreign matters of the present invention having heat resistance is used as the coating film for removing foreign matters. Accordingly, even when the treatment at high temperatures is performed in the second A step, this is unlikely to lead to a defect in the coating film for removing foreign matters, and it is possible to prevent foreign matters from remaining on the substrate by a simple method.

### <<First A Step>>

The first A step is a step of producing a laminate by bonding the semiconductor substrate of the present invention (semiconductor substrate having the coating film for removing foreign matters of the present invention) to a support base material with the coating film for removing foreign matters interposed therebetween.

The support base material is not particularly limited as long as it is a member capable of supporting the semiconductor substrate when the laminate (e.g. the semiconductor substrate) is processed, and examples thereof include a flexible support base material and a glass support base material.

The shape of the support base material is not particularly limited, and examples thereof include a disk shape.

The thickness of the disk-shaped support base material may be appropriately determined depending on the size of the semiconductor substrate and the like, and is not particularly limited, but is, for example, 500 to 1,000 µm.

The diameter of the disk-shaped support base material may be appropriately determined depending on the size of the semiconductor substrate and the like, and is not particularly limited, but is, for example, 100 to 1,000 mm.

An example of the support base material is a glass wafer having a diameter of about 300 mm and a thickness of about 700 µm.

The first A step is preferably a step of producing a laminate by bonding the semiconductor substrate to the support base material with the coating film for removing foreign matters and an adhesive layer interposed therebetween.

The adhesive layer is not particularly limited as long as the support base material can be peeled off from the laminate in the third A step.

The adhesive layer can be formed by a known adhesive and a known method. As the adhesive, for example, an application type of wafer temporarily bonding adhesive described in, for example, WO 2015/190438 A, a temporarily bonding material of Thin Materials AG (Nissan Chemical Corporation), a semiconductor wafer temporarily bonding material manufactured by Toray Industries, Inc., WaferBOND (registered trademark) CR-200 and HT-10.10 (manufactured by Brewer Science, Inc.) may be used, or a tape-shaped adhesive (e.g. a back-grinding tape (e.g. 3MTM temporarily fixing pressure-sensitive adhesive tape ATT-4025 (manufactured by 3M Japan Limited), E-series, P-series, S-series (trade names, manufactured by LINTEC Corporation), ICROS Tape (registered trademark) (manufactured by Mitsui Chemicals Tohcello, Inc.), or a dicing tape (e.g. Solvent Resistance Dicing Tape (trade name, manufactured by Nitto Denko Corporation), a temperature-sensitive adhesive sheet: Intelimer (registered trademark) tape (manufactured by Nitta Corporation), or Intelimer (registered trademark) tape (manufactured by Anchor Techno. Ltd.) may be used.

A wafer adhesive applied to a specific wafer handling system (e.g. Zero Newton (registered trademark), TOKYO OHKA KOGYO CO., LTD.) may be used.

As the adhesive layer, one referred to as a pressure-sensitive adhesive layer, a pressure-sensitive adhesive tape, or a temporarily fixing material may be used. Examples of the pressure-sensitive adhesive layer include a pressure-sensitive adhesive layer described in WO 2021/225163 A, an adhesive layer described in WO 2022/065376 A, and a light-curable type adhesive layer described in WO 2022/065388 A.

For example, the back-grinding tape includes a base material film, a pressure-sensitive adhesive layer, and a release film. As the base material film, a soft thermoplastic film such as an ethylene-vinyl acetate copolymer (EVA) has been used; however, for the purpose of improving the supporting properties of a wafer, the use of a rigid stretched film, such as polyethylene terephthalate (PET), is being attempted. Thereafter, further improvements have been made, and a design of lamination of two types of films having different moduli, for example, a design of lamination of PET and an ethylene copolymer and a design of lamination of polypropylene (PP) and an ethylene copolymer have been reported.

The pressure-sensitive adhesive is generally of an acrylic type. With regard to acrylic type pressure-sensitive adhesives, a design has been known such that cross-linking is caused by reacting a curing agent with an acrylic copolymer from a monomer having a low glass transition temperature, such as butyl acrylate, as the main raw material. Since the back-grinding tape is bonded to the wafer circuit surface, and thus, there is a concern about contamination derived from the pressure-sensitive adhesive after peeling the tape. For this reason, there is a report of a design using an emulsion type pressure-sensitive adhesive with the expectation of removal of potentially remaining pressure-sensitive adhesive by rinsing it with water. However, it is difficult to completely remove the remaining pressure-sensitive adhesive. Therefore, the coating film for removing foreign matters of the present application is formed on the circuit surface and then an adhesive layer is formed, and thus foreign matters (residue of the adhesive layer) caused in the subsequent peeling step can be completely removed by cleaning with a removing liquid. Consequently, the wiring portions including circuits are undamaged.

The thickness of the adhesive layer is not particularly limited, and is, for example, 5 µm to 500 µm, preferably 10 µm to 300 µm, more preferably 20 µm to 200 µm, particularly preferably 30 µm to 150 µm.

Before performing the first A step, the adhesive layer may be formed on the coating film for removing foreign matters, may be formed on the support base material, or may be formed on the semiconductor substrate.

When the adhesive layer is not used, the support base material preferably has a pressure-sensitive adhesive layer. The support base material includes, for example, a flexible support and a pressure-sensitive adhesive layer. Examples of the flexible support include a polyimide film. The pressure-sensitive adhesive layer is not particularly limited, and examples thereof include a layer formed from the pressure-sensitive adhesive described above.

The bonding is performed, for example, under heating and increased pressure.

The heating temperature is not particularly limited as long as it is normal temperature (25°C) or higher, and is ordinarily 50°C or higher. From the viewpoint of avoiding excessive heating, the heating temperature is commonly 220°C or lower. In some aspects, the heating temperature is 170°C or lower.

The load is not particularly limited as long as the substrate and the layer can be bonded and the substrate and the layer are not damaged, and is, for example, 0.5 to 50 kN.

The pressure during bonding is, for example, 0.1 to 20 N/mm². The pressure refers to a force (load) per unit area (mm²) of the substrate in contact with a jig to which the load is applied.

The degree of pressure reduction is not particularly limited as long as the substrate and the layer can be bonded and the substrate and the layer are not damaged, and is, for example, 10 to 10,000 Pa.

When the adhesive layer is used, the layer structure of the laminate produced in the first A step may be a semiconductor substrate/coating film for removing foreign matters/adhesive layer/support base material, for the purpose of removing foreign matters as a peeled residue of the adhesive layer together with the coating film for removing foreign matters in the fourth A step and achieving a state in which no foreign matters exist on the semiconductor substrate.

Further, when the adhesive layer is used, the layer structure of the laminate produced in the first A step may be a semiconductor substrate/adhesive layer/coating film for removing foreign matters/support base material, for the purpose of removing foreign matters as a peeled residue of the adhesive layer together with the coating film for removing foreign matters in the fourth A step and achieving a state in which no foreign matters exist on the support base material. In this case, it is easy to reuse the support base material.

In addition, the layer structure of the laminate produced in the first A step may be a semiconductor substrate/coating film for removing foreign matters/adhesive layer/coating film for removing foreign matters/support base material, for the purpose of, for example, achieving a state in which no foreign matters exist on the semiconductor substrate and the support base material.

The laminate produced in the first A step may have a laser release layer between the semiconductor substrate and the support base material. When the laminate has a laser release layer, in the third A step, for example, the support base material may be peeled off from the laminate by irradiation of the laser release layer with a laser. The laser is applied to the laser release layer from the side of the support base material having laser light transmissivity, for example.

When the laminate has the laser release layer, the layer structure of the laminate produced in the first A step may be, for example, a semiconductor substrate/coating film for removing foreign matters/laser release layer/adhesive layer/support base material, for the purpose of removing foreign matters as a peeled residue of the laser release layer and adhesive layer, together with the coating film for removing foreign matters in the fourth A step and achieving a state in which no foreign matters exist on the semiconductor substrate.

When the laminate has the laser release layer, the layer structure of the laminate produced in the first A step may **be,** for example, a semiconductor substrate/adhesive layer/laser release layer/coating film for removing foreign matters/support base material, for the purpose of removing foreign matters as a peeled residue of the laser release layer and the adhesive layer, together with the coating film for removing foreign matters in the fourth A step and achieving a state in which no foreign matters exist on the support base material. In this case, it is easy to reuse the support base material.

In the case where a peeled residue of the laser release layer remains on the adhesive layer after peeling off the support base material from the laminate by irradiation of the laser release layer with a laser, foreign matters derived from the laser release layer may be reattached to the semiconductor substrate or the support base material, or the time required to clean the adhesive layer may be increased. For the purpose of preventing these problems and removing the residue of the laser release layer on the adhesive layer, the layer structure of the laminate produced in the first A step may be a semiconductor substrate/adhesive layer/coating film for removing foreign matters/laser release layer/support base material, or a semiconductor substrate/laser release layer/coating film for removing foreign matters/adhesive layer/support base material.

### <<Second A Step>>

The second A step is a step of processing the laminate.

The processing in the second A step is not particularly limited, and examples thereof include a process of polishing a semiconductor substrate, a process of forming a through electrode of a semiconductor substrate, and a process of connecting between a semiconductor substrate and a second semiconductor substrate. The processing in the second A step may include one of these processes, or may include two or more of the processes.

### <<Polishing Process>>

The process of polishing a semiconductor substrate is not particularly limited as long as it is a process of polishing the surface of the semiconductor substrate opposite to the surface with the coating film for removing foreign matters to thin the semiconductor substrate, and examples thereof include physical polishing using a polishing agent or a grindstone.

The polishing process can be performed using a general polishing device used for polishing a semiconductor substrate (e.g. a silicon wafer).

The polishing process results in a reduction in the thickness of the semiconductor substrate, and a semiconductor substrate thinned to a desired thickness is formed. The thickness of the thinned semiconductor substrate is not particularly limited. For example, the thickness may be 30 to 300 µm or 30 to 100 µm.

### <<Through Electrode Forming Process>>

For example, a through electrode for realizing conduction between thinned semiconductor substrates when a plurality of thinned semiconductor substrates is stacked may be formed on the polished semiconductor substrate.

Accordingly, a through electrode forming process of forming a through electrode on the polished semiconductor substrate after the polishing process and before the peeling step may be included.

The method for forming a through electrode on the semiconductor substrate is not particularly limited, and examples thereof include forming a through hole and filling the formed through hole with a conductive material.

The through hole is formed by, for example, photolithography.

The filling of the conductive material into the through hole is performed by, for example, a plating technique.

In the second A step, the through electrode forming process may be performed without performing the polishing process.

### <<Connection Process>>

The connection process is, for example, a process of connecting the semiconductor substrate to the second semiconductor substrate.

The second semiconductor substrate is not particularly limited, and examples thereof include the semiconductor substrates exemplified in the description of the semiconductor substrate described above.

The connection process is performed, for example, under heating. Alternatively, the connection process is performed, for example, under increased pressure.

The heating temperature is not particularly limited, and is, for example, 100°C to 350°C.

In the connection process, for example, the wiring of the semiconductor substrate is electrically connected to the wiring of the second semiconductor substrate. Such connection is performed, for example, by connecting the ends of the wiring.

The material, shape, and structure of the wiring in the semiconductor substrate are not particularly limited.

The material, shape, and structure of the wiring in the second semiconductor substrate are not particularly limited.

### <Third A Step>

The third A step is a step of peeling off the support base material from the laminate. The third A step can be said to be a step of separating the semiconductor substrate from the support base material.

Examples of the peeling method include, but are not limited to, solvent peeling, peeling by light irradiation (laser light, non-laser light), mechanical peeling with equipment having a sharp portion (what is called a debonder), and manual peeling between the semiconductor substrate and the support base material.

In particular, in the case where the laminate includes an adhesive layer, and the adhesive layer is an adhesive layer formed using an organic resin that absorbs light and causes deterioration necessary for improving the peeling ability, the adhesive layer can be peeled off by, for example, laser irradiation from the support base material side.

The irradiation with the laser light is performed using, for example, ultraviolet light having a wavelength of 190 nm to 400 nm or 190 nm to 600 nm (e.g. 308 nm, 355 nm, or 532 nm).

The peeling can be performed by setting the processing energy density of the pulse laser to about 50 to 500 mJ/cm².

When the laminate includes an adhesive layer, peeling commonly occurs inside the adhesive layer or at an interface between the adhesive layer and an adjacent substrate or layer (e.g. a coating film for removing foreign matters). The expression that peeling occurs inside the adhesive layer means that the adhesive layer is cleaved.

### <Fourth A Step>

The fourth A step is a step of cleaning the semiconductor substrate or the support base material with a removing liquid to remove the coating film for removing foreign matters.

For example, the coating film for removing foreign matters remains on the semiconductor substrate peeled off from the support base material. Thus, the coating film for removing foreign matters is removed with a removing liquid.

In the fourth A step, for example, foreign matters are removed together with the coating film for removing foreign matters.

In the fourth A step, for example, foreign matters, which are a peeled residue of the adhesive layer, are removed together with the coating film for removing foreign matters.

Examples of the removing liquid include the removing liquids exemplified in the description of the composition for forming a coating film for removing foreign matters of the present invention.

The cleaning method is not particularly limited, and examples thereof include a method for immersing, in a removing liquid, the semiconductor substrate on which the coating film for removing foreign matters remains, and a method for spraying a removing liquid onto the semiconductor substrate on which the coating film for removing foreign matters remains.

Conditions for cleaning are not particularly limited. For example, the temperature of the cleaning liquid is 5°C to 50°C. The cleaning time is appropriately selected from 2 to 500 seconds or 3 to 400 seconds.

For example, it is preferable that the coating film for removing foreign matters can be easily peeled off at room temperature (e.g. 25°C) using a widely used 2.38-mass% tetramethylammonium hydroxide aqueous solution.

### <Second Embodiment>

A second embodiment of the method for producing a processed semiconductor substrate of the present invention includes a first B step, a second B step, a third B step, and a fourth B step.

The first B step is a step of producing a laminate by bonding the semiconductor substrate to the support base material with the coating film for removing foreign matters and an adhesive layer interposed therebetween.

The second B step is a step of processing the laminate.

The third B step is a step of peeling off the support base material from the laminate.

The fourth B step is a step of cleaning the semiconductor substrate or the support base material with a removing liquid to remove the coating film for removing foreign matters.

The processing includes connecting the semiconductor substrate to the second semiconductor substrate.

In the second embodiment, the use of the coating film for removing foreign matters makes it possible to prevent a peeled residue of the adhesive layer from remaining on the semiconductor substrate even when the semiconductor substrate is connected to the second semiconductor substrate while the semiconductor substrate is supported by the support base material.

### <<First B Step>>

The first B step is a step of producing a laminate by bonding the semiconductor substrate to the support base material with the coating film for removing foreign matters and an adhesive layer interposed therebetween.

Examples of the semiconductor substrate include the semiconductor substrates exemplified in the description of the semiconductor substrate of the present invention.

Examples of the support base material include the support base materials exemplified in the description of the first A step.

The coating film for removing foreign matters used in the second embodiment is not limited to the coating film for removing foreign matters of the present invention as long as it is a film capable of removing the peeled residue of the adhesive layer, and various coating films can be used.

Examples of such a coating film include a coating film described in WO 2018/159665 A and a coating film described in WO 2022/019287 A.

The film thickness of the coating film for removing foreign matters is ordinarily 5 nm to 1 µm, preferably 10 nm to 500 nm, most preferably 15 nm to 300 nm.

The coating film for removing foreign matters is preferably formed on the semiconductor substrate.

The method for forming the coating film for removing foreign matters on the semiconductor substrate is not particularly limited, and examples thereof include a method in which a composition for forming the coating film for removing foreign matters is applied onto a semiconductor substrate by an appropriate application method, such as a method using a spinner, a coater, or immersion, and then baked.

The adhesive layer is not particularly limited as long as the support base material can be peeled off from the laminate in the third B step.

Examples of the adhesive layer include the adhesive layers exemplified in the first A step.

Before performing the first B step, the adhesive layer may be formed on the coating film for removing foreign matters, may be formed on the support base material, or may be formed on the semiconductor substrate.

When the adhesive layer is used, the layer structure of the laminate produced in the first B step may be a semiconductor substrate/coating film for removing foreign matters/adhesive layer/support base material, for the purpose of removing foreign matters as a peeled residue of the adhesive layer together with the coating film for removing foreign substances in the fourth B step and achieving a state in which no foreign matters exist on the semiconductor substrate.

Further, when the adhesive layer is used, the layer structure of the laminate produced in the first B step may be a semiconductor substrate/adhesive layer/coating film for removing foreign matters/support base material, for the purpose of removing foreign matters as a peeled residue of the adhesive layer together with the coating film for removing foreign matters in the fourth B step and achieving a state in which no foreign matters exist on the support base material. In this case, it is easy to reuse the support base material.

In addition, the layer structure of the laminate produced in the first B step may be a semiconductor substrate/coating film for removing foreign matters/adhesive layer/coating film for removing foreign matters/support base material, for the purpose of, for example, achieving a state in which no foreign matters exist on the semiconductor substrate and the support base material.

The laminate produced in the first B step may have a laser release layer between the semiconductor substrate and the support base material. When the laminate has a laser release layer, in the third B step, for example, the support base material may be peeled off from the laminate by irradiation of the laser release layer with a laser. The laser is applied to the laser release layer from the side of the support base material having laser light transmissivity, for example.

When the laminate has the laser release layer, the layer structure of the laminate produced in the first B step may **be,** for example, a semiconductor substrate/coating film for removing foreign matters/laser release layer/adhesive layer/support base material, for the purpose of removing foreign matters as a peeled residue of the laser release layer and adhesive layer, together with the coating film for removing foreign matters in the fourth B step and achieving a state in which no foreign matters exist on the semiconductor substrate.

When the laminate has the laser release layer, the layer structure of the laminate produced in the first B step may be, for example, a semiconductor substrate/adhesive layer/laser release layer/coating film for removing foreign matters/support base material, for the purpose of removing foreign matters as a peeled residue of the laser release layer and the adhesive layer, together with the coating film for removing foreign matters in the fourth B step and achieving a state in which no foreign matters exist on the support base material. In this case, it is easy to reuse the support base material.

In the case where a peeled residue of the laser release layer remains on the adhesive layer after peeling off the support base material from the laminate by irradiation of the laser release layer with a laser, foreign matters derived from the laser release layer may be reattached to the semiconductor substrate or the support base material, or the time required to clean the adhesive layer may be increased. For the purpose of preventing these problems and removing the residue of the laser release layer on the adhesive layer, the layer structure of the laminate produced in the first B step may be a semiconductor substrate/adhesive layer/coating film for removing foreign matters/laser release layer/support base material, or a semiconductor substrate/laser release layer/coating film for removing foreign matters/adhesive layer/support base material.

### <<Second B Step>>

The second B step is a step of processing the laminate.

The second B step includes a process of connecting the semiconductor substrate to the second semiconductor substrate as processing of the laminate. That is, the processing includes connecting the semiconductor substrate to the second semiconductor substrate.

The second semiconductor substrate is not particularly limited, and examples thereof include the semiconductor substrates exemplified in the description of the semiconductor substrate described above.

The second B step may include other processes such as a polishing process and a through electrode forming process.

Examples of the connection process include the connection process described in the second A step.

Examples of the polishing process include the polishing process described in the second A step.

Examples of the through electrode forming process include the through electrode forming process described in the second A step.

In the connection process, for example, the wiring of the semiconductor substrate is electrically connected to the wiring of the second semiconductor substrate. Such connection is performed, for example, by connecting the ends of the wiring.

The material, shape, and structure of the wiring in the semiconductor substrate are not particularly limited.

The material, shape, and structure of the wiring in the second semiconductor substrate are not particularly limited.

### <<Third B Step>>

The third B step is a step of peeling off the support base material from the laminate. The third B step can be said to be a step of separating the semiconductor substrate from the support base material.

Specific examples of the third B step include the specific examples exemplified in the third A step.

### <<Fourth B Step>>

The fourth B step is a step of cleaning the semiconductor substrate or the support base material with a removing liquid to remove the coating film for removing foreign matters.

Specific examples of the fourth B step include the specific examples exemplified in the fourth A step.

For example, the coating film for removing foreign matters remains on the semiconductor substrate peeled off from the support base material. Thus, the coating film for removing foreign matters is removed with a removing liquid.

In the fourth B step, for example, foreign matters, which are a peeled residue of the adhesive layer, are removed together with the coating film for removing foreign matters.

Examples of the removing liquid include the removing liquids exemplified in the description of the composition for forming a coating film for removing foreign matters of the present invention.

The cleaning method is not particularly limited, and examples thereof include a method for immersing, in a removing liquid, the semiconductor substrate on which the coating film for removing foreign matters remains, and a method for spraying a removing liquid onto the semiconductor substrate on which the coating film for removing foreign matters remains.

Conditions for cleaning are not particularly limited. For example, the temperature of the cleaning liquid is 5°C to 50°C. The cleaning time is appropriately selected from 2 to 500 seconds or 3 to 400 seconds.

For example, it is preferable that the coating film for removing foreign matters can be easily peeled off at room temperature (e.g. 25°C) using a widely used 2.38-mass% tetramethylammonium hydroxide aqueous solution.

Hereinafter, an example of the second embodiment will be described with reference to the drawings.

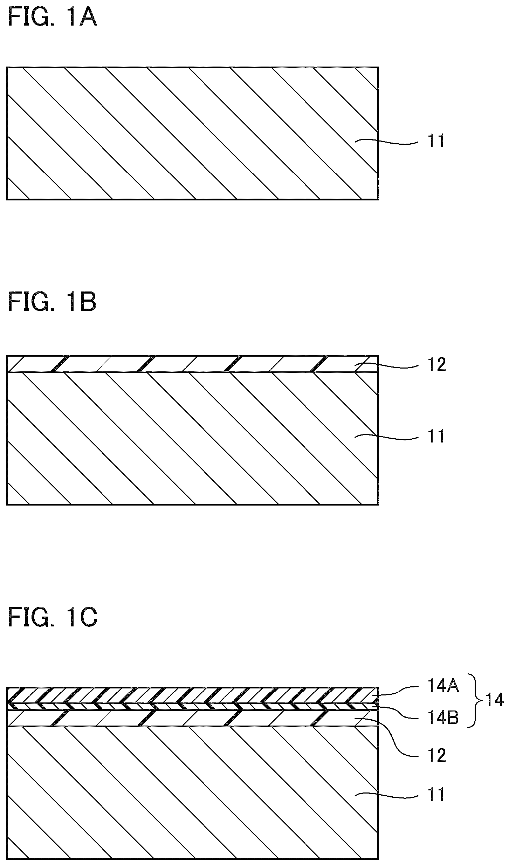

First, a semiconductor substrate 11 is prepared (Fig. 1A).

Next, a coating film for removing foreign matters 12 is formed on the semiconductor substrate 11 (Fig. 1B).

Next, the semiconductor substrate 11 including the coating film for removing foreign matters 12 illustrated in Fig. 1B and a support base material 14 including a flexible support 14A and a pressure-sensitive adhesive layer 14B are bonded such that the coating film for removing foreign matters 12 and the pressure-sensitive adhesive layer 14B face each other (Fig. 1C).

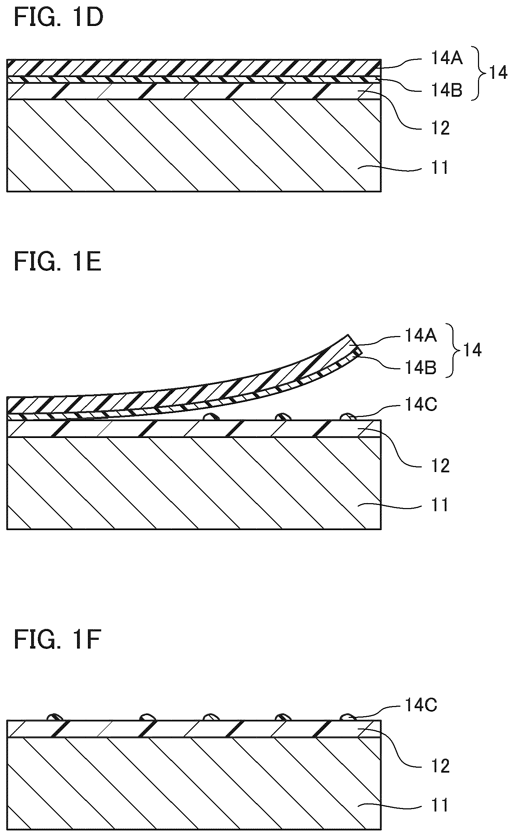

Next, the surface of the semiconductor substrate 11 opposite to the side of the surface on the coating film for removing foreign matters 12 is polished to thin the semiconductor substrate 11 (Fig. 1D).

Next, the support base material 14 is separated from the semiconductor substrate 11 (Figs. 1E and 1F).

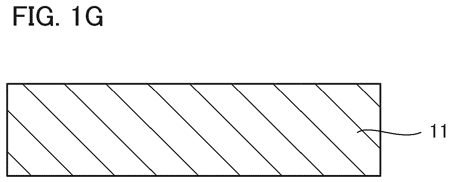

A peeled residue 14C of the pressure-sensitive adhesive layer 14B remains on the coating film for removing foreign matters 12 after separation (Fig. 1F). Thus, the coating film for removing foreign matters 12 is removed with a removing liquid (Fig. 1G). This process makes it possible to prevent the peeled residue 14C, which is a foreign matter, from remaining on the semiconductor substrate 11.

Hereinafter, another example of the second embodiment will be described with reference to the drawings.

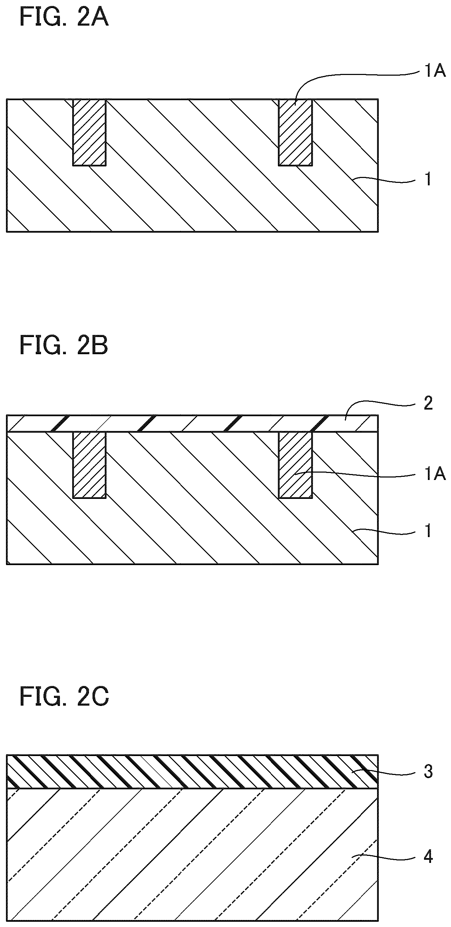

First, a semiconductor substrate 1 having wiring 1A is prepared (Fig. 2A).

Next, a coating film for removing foreign matters 2 is formed on the semiconductor substrate 1 (Fig. 2B).

Meanwhile, a glass substrate 4 having an adhesive layer 3 formed on the surface thereof is prepared (Fig. 2C).

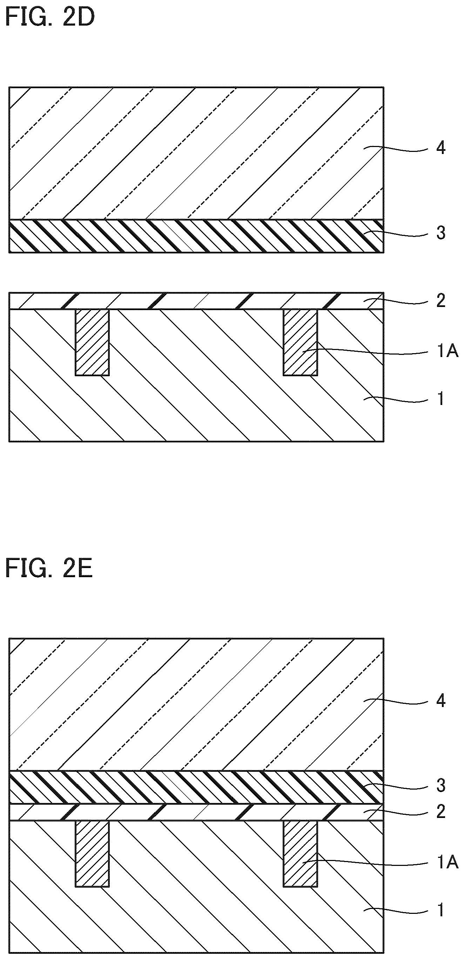

Then, the semiconductor substrate 1 including the coating film for removing foreign matters 2 illustrated in Fig. 2B and the glass substrate 4 including the adhesive layer 3 illustrated in Fig. 2C are bonded such that the coating film for removing foreign matters 2 and the adhesive layer 3 face each other (Figs. 2D and 2E).

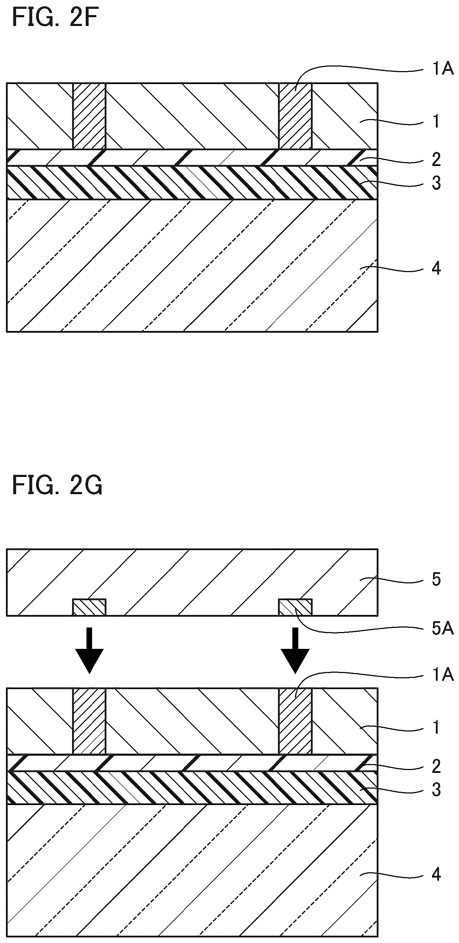

Next, the surface of the semiconductor substrate 1 opposite to the side of the surface on the coating film for removing foreign matters 2 is polished to thin the semiconductor substrate 1 (Fig. 2F). Then, the wiring 1A is exposed.

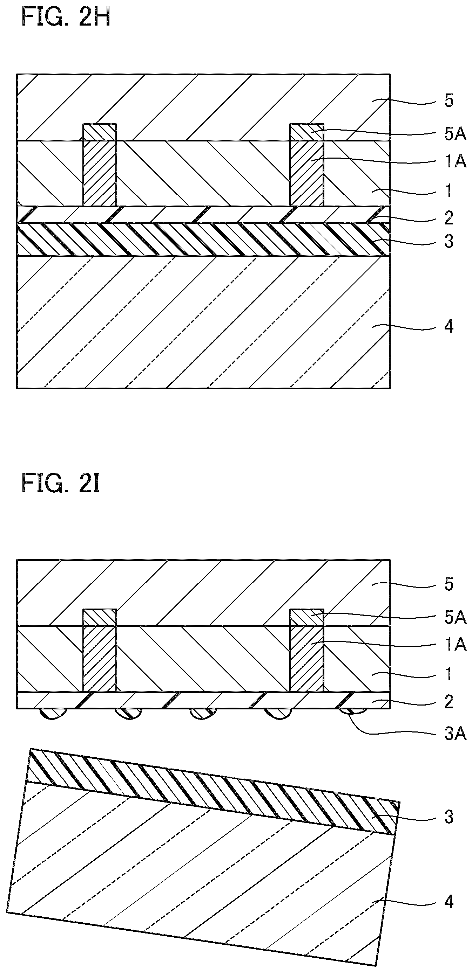

Next, the laminate illustrated in Fig. 2F and a second semiconductor substrate 5 having wiring 5A are bonded such that the surface of the semiconductor substrate 1 opposite to the surface on the side of the coating film for removing foreign matters 2 faces the surface of the second semiconductor substrate 5 on which the wiring 5A is exposed (Figs. 2G and 2H).

Subsequently, the adhesive layer 3 and the glass substrate 4 are separated from the semiconductor substrate 1 (Fig. 2I). The separation can be easily performed, for example, by irradiating the adhesive layer 3 with a laser to lower the adhesive force of the adhesive layer 3.

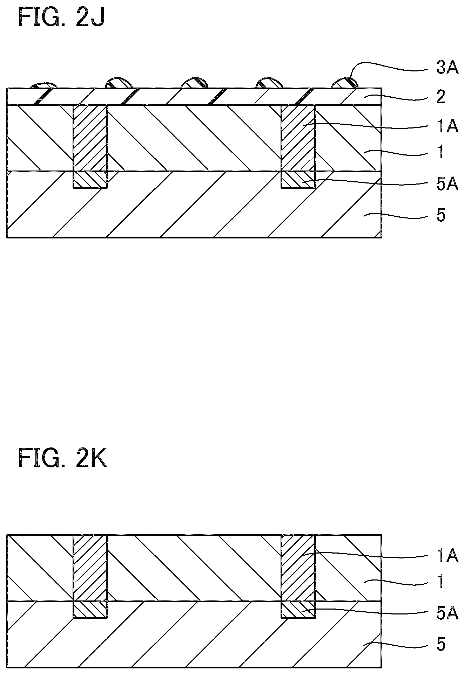

A peeled residue 3A of the adhesive layer 3 remains on the coating film for removing foreign matters 2 after separation (Figs. 2I and 2J). Thus, the coating film for removing foreign matters 2 is removed with a removing liquid (Fig. 2K). This process makes it possible to prevent the peeled residue 3A, which is a foreign matter, from remaining on the semiconductor substrate 1.

The method for producing a processed semiconductor substrate of the present invention can be suitably used for hybrid bonding to connect semiconductor substrates to each other.

### <Another Embodiment>

An embodiment of the present invention may be a method for removing pre-existing foreign matters on a substrate for semiconductor production. For example, WO 2017/056746 A and WO 2020/008965 A disclose a composition for forming a substrate treatment film and a method for treating a substrate, which can efficiently remove minute particles from the surface of the substrate and easily remove the formed substrate treatment film from the substrate surface, in a process for forming a substrate treatment film on the surface of the semiconductor substrate and removing foreign matters from this substrate surface. The composition for forming a coating film for removing foreign matters of the present invention can also be used in the same method/application as described above.

One of the above-described methods will be specifically described below. In this application example, the composition for forming a coating film for removing foreign matters of the present invention is used as a composition for forming a coating film on a semiconductor substrate. First, a step of forming a coating film is performed. That is, the composition for forming a coating film for removing foreign matters is applied onto the semiconductor substrate to form a coating film. The semiconductor substrate may be what is called a solid substrate (flat), which is in an unprocessed state or a state in which various films are formed, or may be a substrate with other shapes such as wiring processed, for the semiconductor device production. Coating methods include, for example, rotary coating (spin coating), cast coating, and roll coating. The coated film is then heated (baked) and/or depressurized to efficiently remove a part or all of the solvent contained in the coated film, thereby accelerating solidification and/or curing of the solid content contained in the coated film. The term "solidification" as used herein means becoming solid, and the term "curing" means an increase in molecular weight (e.g. cross-linking or polymerization) due to the linkage of molecules. In this manner, a coating film is formed. In this process, particles adhering to the circuit of the semiconductor substrate are incorporated into the coating film and efficiently separated from the circuit, or the like. Next, a step of removing a coating film is performed. Specifically, the coating film is entirely removed from the semiconductor substrate by supplying, onto the coating film, a removing liquid that dissolves the coating film. As a result, the particles are removed from the semiconductor substrate together with the coating film.

### Examples

Next, the contents of the present invention will be specifically described with reference to synthesis examples and examples, but the present invention is not limited thereto.

### <Measurement of Molecular Weight>

The weight-average molecular weights of the polymers shown in Synthesis Examples 1 to 4 below are measurement results by gel permeation chromatography (hereinafter abbreviated as GPC). For the measurement, a GPC apparatus manufactured by Tosoh Corporation was used, and measurement conditions and the like were as follows.
· GPC column: Shodex KF803L, Shodex KF802, Shodex KF801 [registered trademark] (Showa Denko K.K.)
· Column temperature: 40°C
· Flow rate: 0.35 ml/min
· Eluent: tetrahydrofuran (THF)
· Standard sample: polystyrene (Tosoh Corporation)

### <Synthesis Example 1>

A reaction flask in which 4.2 g of mesitylene was added to 2.17 g of diallyl isocyanurate, 2.00 g of 1,4-bis(dimethylsilyl)benzene, and 0.02 g of a Karstedt's catalyst (1% as Pt) was heated and stirred at 130°C for 17 hours under a nitrogen atmosphere. Thereafter, mesitylene was distilled off, and the resulting reaction product was subjected to GPC analysis and found to have a weight-average molecular weight of 6,400 in terms of standard polystyrene. The reaction product has the following repeating units.

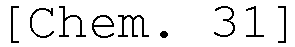

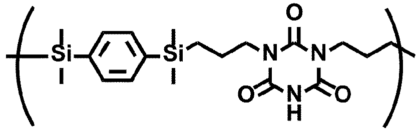

### <Synthesis Example 2>

A reaction flask in which 5.73 g of mesitylene was added to 2.54 g of diallyl isocyanurate, 1.16 g of 1,4-bis(dimethylsilyl)benzene, 2.00 g of 1,1,5,5-tetramethyl-3,3-diphenyltrisiloxane, and 0.02 g of a Karstedt's catalyst (1% as Pt) was heated and stirred at 130°C for 15 hours under a nitrogen atmosphere. Thereafter, mesitylene was distilled off, and the resulting reaction product was subjected to GPC analysis and found to have a weight-average molecular weight of 4,400 in terms of standard polystyrene. The reaction product has the following repeating units.

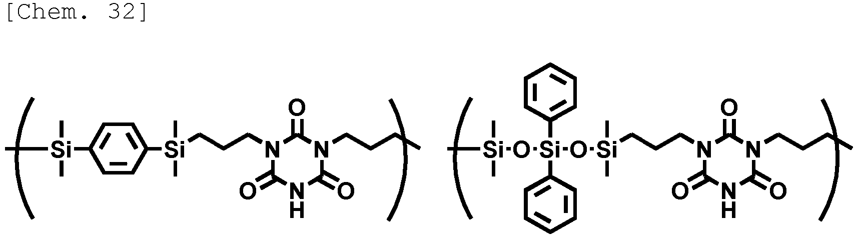

### <Synthesis Example 3>

A reaction flask in which 4.45 g of mesitylene was added to 2.36 g of diallyl isocyanurate, 2.00 g of 1,4-bis(dimethylsilyl)benzene, 0.16 g of 1,3-diisopropenylbenzene, and 0.02 g of a Karstedt's catalyst (1% as Pt) was heated and stirred at 130°C for 18 hours under a nitrogen atmosphere. Thereafter, mesitylene was distilled off, and the resulting reaction product was subjected to GPC analysis and found to have a weight-average molecular weight of 5,200 in terms of standard polystyrene. The reaction product has the following repeating units.

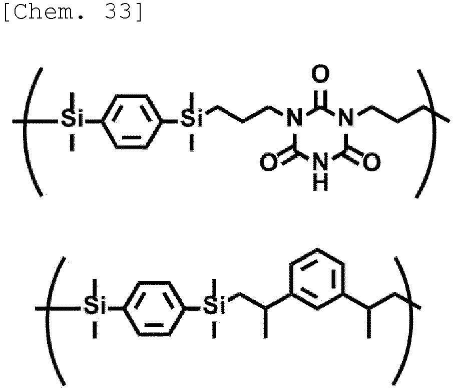

### <Synthesis Example 4>

A reaction flask in which 4.83 g of mesitylene was added to 2.36 g of diallyl isocyanurate, 2.00 g of 1,4-bis(dimethylsilyl)benzene, 0.44 g of 9,9-bis(4-allyloxyphenyl)fluorene, and 0.02 g of a Karstedt's catalyst (1% as Pt) was heated and stirred at 130°C for 20 hours under a nitrogen atmosphere. Thereafter, mesitylene was distilled off, and the resulting reaction product was subjected to GPC analysis and found to have a weight-average molecular weight of 3,500 in terms of standard polystyrene. The reaction product has the following repeating units.

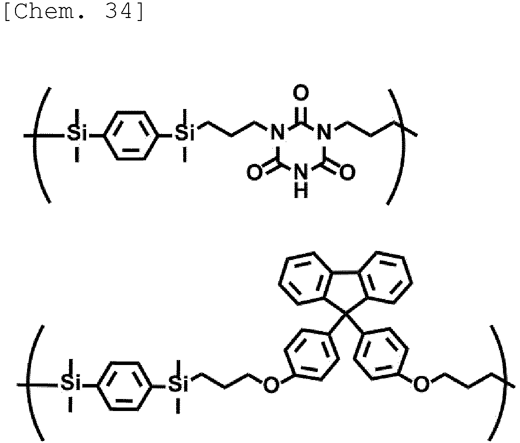

### <Example 1>

After 9.6 g of N-ethyl-2-pyrrolidone was added to 0.4 g of the reaction product obtained in Synthesis Example 1, the mixture was filtered using a PTFE syringe filter having a pore size of 0.20 µm to prepare a resin composition solution.

### <Example 2>

After 9.6 g of N-ethyl-2-pyrrolidone was added to 0.4 g of the reaction product obtained in Synthesis Example 2, the mixture was filtered using a PTFE syringe filter having a pore size of 0.20 µm to prepare a resin composition solution.

### <Example 3>

After 9.6 g of N-ethyl-2-pyrrolidone was added to 0.4 g of the reaction product obtained in Synthesis Example 3, the mixture was filtered using a PTFE syringe filter having a pore size of 0.20 µm to prepare a resin composition solution.

### <Example 4>

After 9.6 g of N-ethyl-2-pyrrolidone was added to 0.4 g of the reaction product obtained in Synthesis Example 4, the mixture was filtered using a PTFE syringe filter having a pore size of 0.20 µm to prepare a resin composition solution.

### <Comparative Example 1>

The composition for forming a coating film for removing foreign matters of Example 1 of WO 2018/159665 A was prepared as follows and used as a composition for forming a coating film for removing foreign matters of Comparative Example 1.

### <<Synthesis of Polyamic Acid>>

A solution [A] containing a polyamic acid was obtained by allowing 4.36 g of pyromellitic dianhydride, 1.19 g of diaminobenzoic acid, and 4.26 g of 2,2-bis(3-amino-4-tolyl)hexafluoropropane to react in 55.6 g of propylene glycol monomethyl ether at 60°C for 25 hours.

### <<Synthesis of Light-Absorbing Compound>>

A solution [a] containing a light-absorbing compound was obtained by allowing 19.0 g of 3,7-dihydroxy-2-naphthoic acid, 10 g of tris(2,3-epoxypropyl) isocyanurate, and 0.552 g of benzyltriethylammonium chloride to react in 118 g of cyclohexanone at 130°C for 24 hours.

### <<Preparation of Composition for Forming Coating Film for Removing Foreign Matters>>

To 14.0 g of the solution [A] containing a polyamic acid, 4.38 g of the solution [a] containing a light-absorbing compound, 0.630 g of tris(2,3-epoxypropyl) isocyanurate, 52.3 g of propylene glycol monomethyl ether, and 67.5 g of propylene glycol monomethyl ether acetate were added and stirred at room temperature for 30 minutes to prepare a solution [1] of a composition for forming a coating film for removing foreign matters.

### [Alkali Dissolution Test after Heat Resistance Test]

Each of the resin composition solutions prepared in Examples 1 to 4 and Comparative Example 1 was applied (spin coated) onto a silicon wafer with a spin coater. The silicon wafer after the application was heated on a hot plate at 205°C for 1 minute to form a coating film having a thickness of 40 nm. Further, this coating film was treated at a high temperature on a hot plate at 300°C for 30 minutes under nitrogen. Next, in order to determine the alkali solubility of the coating film, the silicon wafer after formation of the coating film was immersed in a 2.38% tetramethylammonium hydroxide aqueous solution (alkali solvent, NMD-3, manufactured by TOKYO OHKA KOGYO CO., LTD.) for 1 minute. The film thicknesses of the coating film before and after immersion in the alkali solvent were measured with a light interference film thickness meter (product name: Lambda Ace VM-3210, manufactured by SCREEN Holdings Co., Ltd.).

The alkali solubility was evaluated by calculating the film thickness reduction rate (%) of the coating film removed by immersion in the solvent according to the following calculation formula: Film thickness reduction rate (%) = ((A - B) ÷ A) × 100
A: Film thickness before solvent immersion
B: Film thickness after solvent immersion

Table 1 shows the results. When the film thickness reduction rate is about 99% or more, it can be said that the film has sufficient alkali solubility.

**[Table 1]**

| | Film thickness reduction rate |
|---|---|
| Example 1 | > 99% |
| Example 2 | > 99% |
| Example 3 | > 99% |
| Example 4 | > 99% |
| Comparative Example 1 | 0 |

From the above results, it was confirmed that the resin composition solutions of Examples 1 to 4 were dissolved in an alkali solvent after the heat resistance treatment. In addition, as compared with Comparative Example 1, it can be said that good solubility in an alkali solvent is exhibited.

### Reference Signs List

- 1: Semiconductor substrate
- 1A: Wiring
- 2: Coating film for removing foreign matters
- 3: Adhesive layer
- 4: Glass substrate
- 5: Second semiconductor substrate
- 5A: Wiring
- 11: Semiconductor substrate
- 12: Coating film for removing foreign matters
- 14: Support base material
- 14A: Flexible support
- 14B: Pressure-sensitive adhesive layer
- 14C: Peeled residue

## Claims

1. A composition for forming a coating film for removing foreign matters, comprising: a polymer; and a solvent, the composition being capable of forming a coating film that is removable with a removing liquid,
wherein the polymer is a polymer containing a structure represented by Formula (1) below: 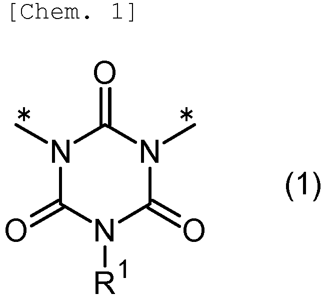
wherein, in Formula (1), R¹ represents a hydrogen atom, a protecting group of an imide group deprotected by an alkali, or a protecting group of an imide group deprotected by an acid, and * represents a bond.

2. The composition according to claim 1, wherein the polymer further contains a structure represented by Formula (2) below: 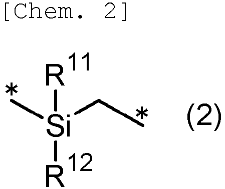 wherein, in Formula (2), R¹¹ and R¹² each independently represent an optionally substituted alkyl group having 1 to 10 carbon atoms, an optionally substituted phenyl group, or an optionally substituted phenoxy group, and * represents a bond.

3. The composition according to claim 1, wherein the polymer is a polymer obtained by a hydrosilylation reaction between a compound having a Si-H group and a compound having a carbon-carbon unsaturated bond capable of a hydrosilylation reaction.

4. The composition according to claim 3, wherein the compound having a carbon-carbon unsaturated bond includes a compound represented by Formula (1A) below: 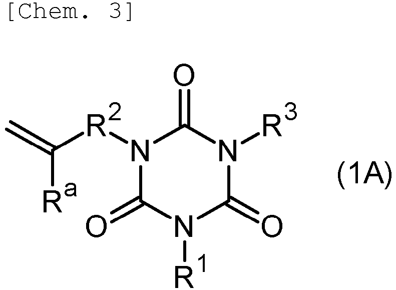
wherein, in Formula (1A), R¹ represents a hydrogen atom, a protecting group of an imide group deprotected by an alkali, or a protecting group of an imide group deprotected by an acid,
R² represents a divalent group having 1 to 6 carbon atoms,
R³ represents a hydrogen atom, a protecting group of an imide group deprotected by an alkali, a protecting group of an imide group deprotected by an acid, or a group represented by Formula (1A-1) below, and
R² represents a hydrogen atom or a methyl group, 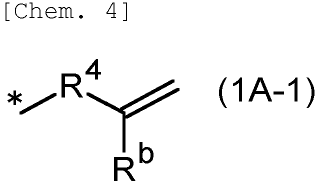
wherein, in Formula (1A-1), R⁴ represents a divalent group having 1 to 6 carbon atoms, R^{b} represents a hydrogen atom or a methyl group, and * represents a bond.

5. The composition according to claim 3, wherein the compound having a Si-H group includes at least one of a compound represented by Formula (2A) below, a cyclic siloxane compound represented by Formula (2B) below, and a silsesquioxane having a Si-H group: 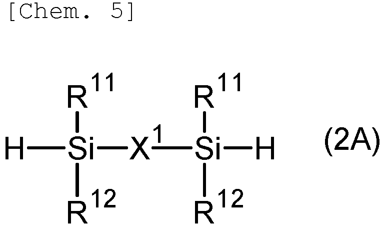
wherein, in Formula (2A), R¹¹s and R¹²s each independently represent an optionally substituted alkyl group having 1 to 10 carbon atoms, an optionally substituted phenyl group, or an optionally substituted phenoxy group,
X¹ represents a single bond, an organic group having 1 to 10 carbon atoms, or a group represented by Formula (2A-1) below, 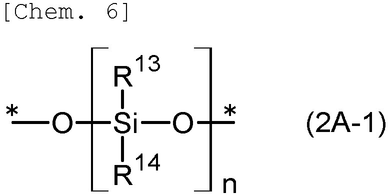
wherein, in Formula (2A-1), R¹³ and R¹⁴ each independently represent an optionally substituted alkyl group having 1 to 10 carbon atoms, an optionally substituted phenyl group, or an optionally substituted phenoxy group, n represents an integer of 0 to 10, and * represents a bond, 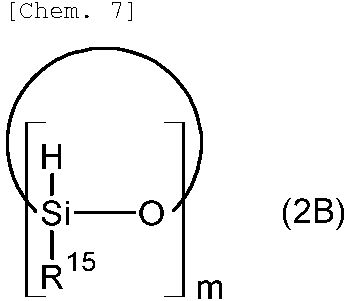
wherein, in Formula (2B), R¹⁵ each independently represents an optionally substituted alkyl group having 1 to 10 carbon atoms, an optionally substituted phenyl group, or an optionally substituted phenoxy group, and m represents an integer of 3 to 6.

6. The composition according to claim 1, wherein the removing liquid is an alkaline removing liquid.

7. The composition according to claim 1, wherein the removing liquid is a removing liquid containing an organic solvent in an amount of 50 mass% or more.

8. The composition according to claim 1, comprising at least one of a crosslinking agent and an additive.

9. A coating film for removing foreign matters, comprising the composition according to any one of claims 1 to 8.

10. The coating film for removing foreign matters according to claim 9, wherein a film thickness of the coating film decreases by 5% or less when the coating film is heated at 250°C for 10 minutes in a nitrogen atmosphere.

11. A semiconductor substrate comprising the coating film for removing foreign matters according to claim 9.

12. A method for producing a processed semiconductor substrate, comprising:
a first A step of producing a laminate by bonding the semiconductor substrate according to claim 11 to a support base material with the coating film for removing foreign matters interposed therebetween;
a second A step of processing the laminate;
a third A step of peeling off the support base material from the laminate; and
a fourth A step of cleaning the semiconductor substrate or the support base material with a removing liquid to remove the coating film for removing foreign matters.

13. The method for producing a processed semiconductor substrate according to claim 12, wherein in the fourth A step, foreign matters are removed together with the coating film for removing foreign matters.

14. The method for producing a processed semiconductor substrate according to claim 12, wherein the first A step is a step of producing a laminate by bonding the semiconductor substrate to the support base material with the coating film for removing foreign matters and an adhesive layer interposed therebetween.

15. The method for producing a semiconductor substrate according to claim 14, wherein in the fourth A step, foreign matters as a peeled residue of the adhesive layer are removed together with the coating film for removing foreign matters.

16. The method for producing a processed semiconductor substrate according to claim 12, wherein the processing includes connecting the semiconductor substrate to a second semiconductor substrate.
